# EUROPEAN PATENT SPECIFICATION

(11) **EP 4 645 146 B1**
(45) Date of publication and mention of the grant of the patent: **02.12.2026**
(21) Application number: 23910736.0
(22) Date of filing: 27.12.2023
(51) Int. Cl.: G06F 30/10, G06T 1/20, G06T 15/00

(54) **GEOMETRIC SHAPE STREAMING DATA PROCESSING METHOD AND APPARATUS, COMPUTING DEVICE, STORAGE MEDIUM, AND COMPUTER PROGRAM PRODUCT**
VERFAHREN UND VORRICHTUNG ZUR VERARBEITUNG VON STREAMINGDATEN MIT GEOMETRISCHER FORM, COMPUTERVORRICHTUNG, SPEICHERMEDIUM UND COMPUTERPROGRAMMPRODUKT
PROCÉDÉ ET APPAREIL DE TRAITEMENT DE DONNÉES DE DIFFUSION EN CONTINU DE FORME GÉOMÉTRIQUE, DISPOSITIF INFORMATIQUE, SUPPORT DE STOCKAGE ET PRODUIT-PROGRAMME D'ORDINATEUR

(30) Priority: 29.12.2022 CN 202211702237
(43) Date of publication of application: 05.11.2025
(73) Proprietor: Moore Threads Technology Co., Ltd., Beijing 100036 (CN)
(72) Inventor: ZHU, Xinzhao, Beijing 100036 (CN); YANG, Lei, Beijing 100036 (CN); ZHANG, Yubo, Beijing 100036 (CN)
(74) Representative: Lavoix
(86) International application number: PCT/CN2023/142406
(87) International publication number: WO 2024/140818

(56) References cited:
- CN-A- 109 791 574
- CN-A- 112 270 641
- CN-A- 115 659 443
- US-A1- 2021 064 791
- US-A1- 2021 232 716
- US-B1- 8 558 842
- US-B1- 9 501 847

## Description

### CROSS-REFERENCE TO RELATED APPLICATION

This application is filed based on and claims priority to Chinese Patent Application No. 202211702237.5 filed on December 29, 2022 and entitled "METHOD AND APPARATUS FOR PROCESSING GEOMETRY STREAM DATA, COMPUTING DEVICE, AND STORAGE MEDIUM".

### TECHNICAL FIELD

The disclosure relates to the technical field of computers, and in particular, to a method and apparatus for processing geometry stream data, computing device, computer-readable storage medium, and computer program product.

### BACKGROUND

In an application related to computer graphics, the application expresses a graphic model as geometry stream data, and a system for processing geometry stream data receives the geometry stream data from a memory according to an instruction of the application, and splits, according to a topology specified by the application, the geometry stream data into primitive geometries such as basic points, lines, triangles, or customized shapes, etc. However, efficiency of processing geometry stream data in the related art is low.

Related art can be found in US 8 558 842 B1 and US 9 501 847 B1.

### SUMMARY

In view of the above, the disclosure provides a method and apparatus for processing geometry stream data, computing device, computer-readable storage medium, and computer program product, which are desired to alleviate or overcome a part or all of the above-mentioned defects and other possible defects.

The invention is defined in the claims.

In the method and apparatus for processing geometry stream data according to some embodiments of the disclosure, in case that no shearing point is present in the to-be-processed geometry stream data, the geometry pipeline allocation module of each of the geometry pipelines only needs to acquire the target data from the to-be-processed geometry stream data, and split the target data to obtain the data of primitive geometries (data of primitive geometries to be processed by the geometry pipeline in the current batch), instead of having to acquire all the to-be-processed geometry stream data. Therefore, throughput of the geometry pipeline allocation module of each of the geometry pipelines upon acquiring data each time is significantly reduced, and splitting efficiency of the geometry pipeline is greatly improved.

These and other advantages of the disclosure will become apparent from embodiments described below, and will be clarified with reference to the embodiments described below.

### BRIEF DESCRIPTION OF THE DRAWINGS

The embodiments of the disclosure will be described now in more detail and with reference to the drawings, in which:
FIG. 1 is an exemplary application scenario of a method for processing geometry stream data provided in an embodiment of the disclosure;
FIG. 2 is a flowchart of a method for processing geometry stream data provided in an embodiment of the disclosure;
FIG. 3 is a flowchart of a method for processing geometry stream data including shearing point data provided in an embodiment of the disclosure;
FIG. 4 is a flowchart of a method for processing geometry stream data provided in an embodiment of the disclosure;
FIG. 5 is a schematic diagram of acquiring target data from geometry stream data having a point list in a method for processing geometry stream data provided in an embodiment of the disclosure;
FIG. 6 is a schematic diagram of acquiring target data from geometry stream data having a line list in a method for processing geometry stream data provided in an embodiment of the disclosure;
FIG. 7 is a schematic diagram of acquiring target data from geometry stream data having a line list with adjacency information in a method for processing geometry stream data provided in an embodiment of the disclosure;
FIG. 8 is a schematic diagram of acquiring target data from geometry stream data having a line strip in a method for processing geometry stream data provided in an embodiment of the disclosure;
FIG. 9 is a schematic diagram of acquiring target data from geometry stream data having a line strip with adjacency information in a method for processing geometry stream data provided in an embodiment of the disclosure;
FIG. 10 is a schematic diagram of acquiring target data from geometry stream data having a line loop in a method for processing geometry stream data provided in an embodiment of the disclosure;
FIG. 11 is a schematic diagram of acquiring target data from geometry stream data having a triangle list in a method for processing geometry stream data provided in an embodiment of the disclosure;
FIG. 12 is a schematic diagram of acquiring target data from geometry stream data having a triangle list with adjacency information in a method for processing geometry stream data provided in an embodiment of the disclosure;
FIG. 13 is a schematic diagram of acquiring target data from geometry stream data having a triangle strip in a method for processing geometry stream data provided in an embodiment of the disclosure;
FIG. 14 is an exemplary structural block diagram of another apparatus for processing geometry stream data provided in an embodiment of the disclosure;
FIG. 15 is an exemplary system provided in an embodiment of the disclosure, the system includes an exemplary computing device representing one or more systems and/or devices which may implement various methods described here.

### DETAILED DESCRIPTION

Exemplary embodiments will be described now more comprehensively with reference to the drawings. However, the exemplary embodiments may be implemented in many forms, and should not be understood as being limited to the embodiments set forth here; instead, these embodiments are provided so that the disclosure will be comprehensive and complete, and concepts of the exemplary embodiments will be comprehensively conveyed to those skilled in the art. The same reference numeral in the drawings represents the same or similar parts, and thus repeated descriptions thereof will be omitted.

Furthermore, described features, structures or characteristics may be combined in one or more embodiments in any suitable manner. In the following descriptions, many specific details are provided to provide full understanding of the embodiments of the disclosure. However, it will be appreciated by those skilled in the art that technical solutions of the disclosure may be practiced without one or more of the specific details, or other methods, components, apparatuses, steps or the like may be used. In other cases, known methods, apparatuses, implementations or operations are not shown or described in detail, to avoid obscuring various aspects of the disclosure.

Block diagrams shown in the drawings are only functional entities, and do not necessarily correspond to physically independent entities. That is, these functional entities may be implemented in form of software, or these functional entities may be implemented in one or more hardware modules or Integrated Circuits (ICs), or these functional entities may be implemented in different networks and/or processor apparatuses and/or microcontroller apparatuses.

Flowcharts shown in the drawings are only exemplary explanations, and do not necessarily include all the contents and operations/steps, nor must they be performed in described orders. For example, some operations/steps may be decomposed, and some operations/steps may be combined or partially combined, therefore actual execution orders may change according to actual conditions.

It should be understood that although terms "first", "second", "third" or the like may be used here to describe various components, these components should not be limited by these terms. These terms are only used to distinguish one component from another component. Therefore, a first component discussed below may be referred to as a second component without departing from teaching of concepts of the disclosure. As used here, a term "and/or" and similar terms include any one or more of associated listed items, and all combinations of all the associated listed items.

It may be understood by those skilled in the art that the drawings are only schematic diagrams of the exemplary embodiments, and modules or processes in the drawings are not necessarily required for implementing the disclosure, and thus cannot be used to limit the scope of protection of the disclosure.

Before the embodiments of the disclosure are described in detail, some relevant concepts are explained first for the sake of clarity.

Geometry stream data: the geometry stream data includes multiple point data which are used to represent information of a point in a topology. The topology includes a point list, a line list, a triangle list, a line strip, a triangle strip, a line list with adjacency information, a triangle list with adjacency information, a line strip with adjacency information, a triangle strip with adjacency information, a line loop, or a control package list with k points (k is a positive integer), or other topologies.

Primitive geometries: the primitive geometries refer to primitive geometries constituting a graphic model, and including points, lines, triangles, etc. For example, with respect to a graphic model created by an application, the graphic is represented by splicing a large number of triangles in a computer. After the geometry stream data is split into corresponding primitive geometries, a geometry pipeline processor may use these primitive geometries to determine the graphic model according to splicing information of these primitive geometries.

Geometry pipeline: the geometry pipeline is configured to acquire to-be-processed geometry stream data, and split the to-be-processed geometry stream data into data of corresponding primitive geometries, and finally splice the data of primitive geometries obtained from splitting, to obtain the graphic model. The geometry pipeline includes two parts. A first part is a geometry pipeline allocation module configured to acquire the to-be-processed geometry stream data and split the to-be-processed geometry stream data into the data of corresponding primitive geometries. A second part is a geometry pipeline processor configured to process the geometry stream data obtained from splitting by the geometry pipeline allocation module into the graphic model.

In the related art, a unified allocation module is provided in a system for processing geometry stream data, to split all the geometry stream data, therefore splitting efficiency of the unified allocation module may become a bottleneck of performance of the system for processing geometry stream data, and the efficiency is low. Furthermore, in order to accelerate processing, multiple geometry pipelines may be provided for processing. Since the geometry stream data may contain a shearing point, and the shearing point indicates that no common vertex is present between a topology where a previous point data is located and a topology where a next point data is located, then each of the geometry pipelines needs to split all geometry stream data in a memory to obtain all the geometry stream data, and then select a part of the geometry stream data to be processed by the geometry pipeline processor. In this case, the more the geometry pipelines are provided, the greater the access to the memory is, and each of the geometry pipelines performs a lot of unnecessary splitting operations, thereby having a very low efficiency. In case that multiple geometry pipelines are provided to process the geometry stream data, how to improve processing efficiency is a problem to be solved urgently.

The disclosure provides a method for processing geometry stream data which may effectively improve the processing efficiency to improve the foregoing defects. Next, reference will be made to multiple embodiments to explain how to implement the method for processing geometry stream data in detail.

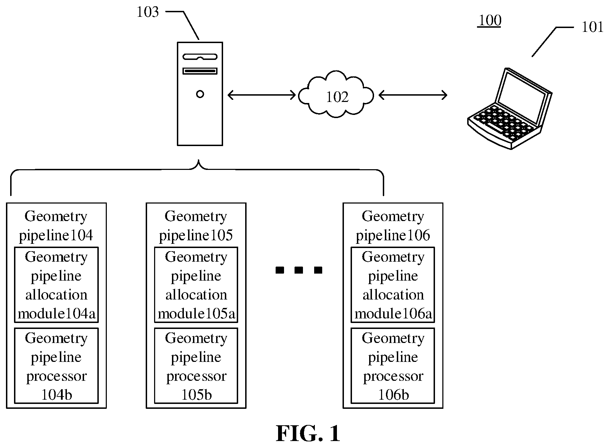

FIG. 1 shows an exemplary application scenario 100 of a method for processing geometry stream data provided in an embodiment of the disclosure. The application scenario 100 may include a client 101, a network 102, and a service unit 103, the service unit 103 is communicatively coupled to the client 101 through the network 102, the service unit 103 includes several geometry pipelines 104, 105,..., 106, and each of the geometry pipelines may include a geometry pipeline allocation module (such as 104a, 105a, 106a) and a geometry pipeline processor (such as 104b, 105b, 106b).

In this embodiment, the method for processing geometry stream data is performed by a target geometry pipeline allocation module in the service unit 103, the target geometry pipeline allocation module is one of several geometry pipeline allocation modules 104a, 105a,..., 106a included in a system for processing geometry stream data, the system for processing geometry stream data includes multiple geometry pipelines 104, 105,..., 106 of which each includes a geometry pipeline allocation module and a geometry pipeline processor. Although FIG. 1 only shows that one geometry pipeline includes one geometry pipeline processor, this is not limiting, one geometry pipeline may include one geometry pipeline allocation module and multiple geometry pipeline processors, and the geometry pipeline allocation module splits the geometry stream data for multiple geometry pipeline processors. In this embodiment, explanation is made by taking the geometry pipeline allocation module 104a of the geometry pipeline 104 as the target geometry pipeline allocation module.

In this embodiment, the geometry pipeline allocation module 104a of the geometry pipeline 104 in the service unit 103 acquires a data processing request, here the data processing request indicates a topology of a to-be-processed geometry stream data and whether the to-be-processed geometry stream data includes shearing point data, and the shearing point data indicates that no common vertex is present between a topology where a previous point data of the shearing point data is located and a topology where a next point data of the shearing point data is located.

The geometry pipeline allocation module 104a of the geometry pipeline 104 in the service unit 103 may directly acquire the data processing request from the client 101 through the network 102, or may acquire the data processing request from an application in the service unit 103 through an interface of the application. For example, the network 102 may be a Wide Area Network (WAN), a Local Area Network (LAN), a wireless network, a public telephone network, an intranet, and any other types of networks known to those skilled in the art.

In response to the to-be-processed geometry stream data not including the shearing point data, the geometry pipeline allocation module 104a of the geometry pipeline 104 in the service unit 103 acquires target data to be split in a current batch from the to-be-processed geometry stream data, here the target data is at least a part of the to-be-processed geometry stream data. In this embodiment, the geometry pipeline allocation module 104a of the geometry pipeline 104 may acquire only a part of the to-be-processed geometry stream data.

Finally, the geometry pipeline allocation module 104a of the geometry pipeline 104 in the service unit 103 splits the target data into data of corresponding primitive geometries according to the topology of the to-be-processed geometry stream data, to be processed by a geometry pipeline processor in a target geometry pipeline, here the target pipeline is a geometry pipeline to which the target pipeline allocation module belongs. According to requirements of an application in the client 101, the graphic model obtained from processing may be transmitted to the application in the client 101 through the network 102.

In the application scenario shown in FIG. 1, the method for processing geometry stream data according to some embodiments of the disclosure is implemented in the target geometry pipeline allocation module on the service unit 103, however, this is only illustrative rather than limiting. The method for processing geometry stream data according to some embodiments of the disclosure may also be implemented in a target geometry pipeline allocation module on other entities with sufficient computing resources and computing capabilities, for example, it may be implemented in a target geometry pipeline allocation module on the client 101 with sufficient computing resources and computing capabilities, etc. Of course, each target geometry pipeline allocation module may also be partially implemented on the service unit 103 and partially implemented on the client 101, which is not limiting.

As understood by those of ordinary skill in the art, an instance of the service unit 103 may be an independent physical server, or a server cluster or a distributed system composed of multiple physical servers, or a cloud server providing basic cloud computing services such as cloud services, cloud databases, cloud computing, cloud functions, cloud storage, network services, cloud communications, middleware services, domain name services, security services, Content Delivery Networks (CDN), big data and artificial intelligence platforms, etc. The server may be directly or indirectly connected through wired or wireless communication, which is not limited in the disclosure.

The client 101 may be any type of mobile computing device, including a mobile computer (such as a Personal Digital Assistant (PDA), a laptop computer, a notebook computer, a tablet computer, a netbook, etc.), a mobile phone (such as a cellular phone, a smart phone, etc.), a wearable computing device (such as a smart watch, a head-mounted device including smart glasses, etc.), or other types of mobile devices. In some embodiments, the client 101 may also be a fixed computing device, such as a desktop computer, a game console, a smart TV, etc.

As shown in FIG. 1, the client 101 may include a display screen and a terminal application which may interact with a terminal user through the display screen. The terminal application may be a local application, a Web application, or a lite application as a lightweight application (Lite App, such as a mobile phone lite application, a WeChat lite application). In case that the terminal application is a local application which needs to be installed, the terminal application may be installed on the client 101. In case that the terminal application is a Web application, the terminal application may be accessed through a browser. In case that the terminal application is a lite application, the terminal application may be directly opened on the client 101 by searching relevant information of the terminal application (such as a name of the terminal application, etc.), scanning a graphic code (such as a barcode, a two-dimensional code, etc.) of the terminal application or other manners, without installing the terminal application.

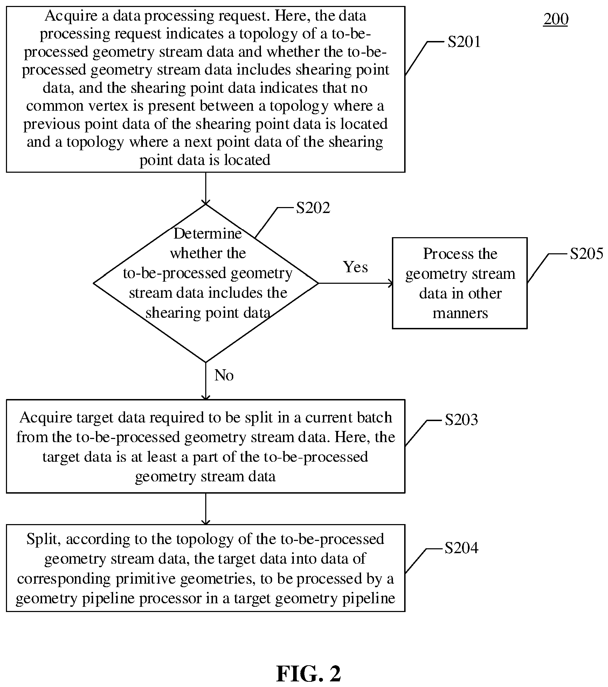

FIG. 2 is a flowchart 200 of a method for processing geometry stream data provided in an embodiment of the disclosure. The method for processing geometry stream data is performed by a target geometry pipeline allocation module, the target geometry pipeline allocation module is one of multiple geometry pipeline allocation modules included in a system for processing geometry stream data, the system for processing geometry stream data includes multiple geometry pipelines of which each includes a geometry pipeline allocation module and a geometry pipeline processor. As shown in FIG. 2, the method for processing geometry stream data according to some embodiments of the disclosure may include the following operations S201 to S205.

In operation S201, a data processing request is acquired, here the data processing request indicates a topology of a to-be-processed geometry stream data and whether the to-be-processed geometry stream data includes shearing point data, and the shearing point data indicates that no common vertex is present between a topology where a previous point data of the shearing point data is located and a topology where a next point data of the shearing point data is located.

With respect to a specific geometry stream data, it has a specific topology, and each point data from the geometry stream data except the shearing point data is a point constituting the topology. For example, with respect to geometry stream data having a triangle strip topology, the geometry stream data is used to represent a triangle strip, rather than other topologies, and each point is a point in the triangle strip. In some implementations, the topology is often specified in the data processing request received by the system for processing geometry stream data. With respect to the shearing point data, since for example a common vertex is present between corresponding primitive geometries in a strip-shaped topology such as a triangle strip, a line strip or the like, it may be necessary to add a shearing point to the geometry stream data according to requirements of splicing the graphic model, so that no common vertex is present between a topology where a previous point data of the shearing point data is located and a topology where a next point data of the shearing point data is located. For example, with respect to geometry stream data having a triangle strip, the 1^{st} to 3^{rd} point data constitute data of a first triangle, the 2^{nd} to 4^{th} point data constitute data of a second triangle, and if the 5^{th} point data is the shearing point data, the 6^{th} to 8^{th} point data constitute data of a third triangle, and if no shearing point data is present in the geometry stream data having a triangle strip topology, the 3^{rd} to 5^{th} point data constitute data of the third triangle. Therefore, existence of the shearing point is crucial to splitting the geometry stream data.

In operation S202, it is determined whether the to-be-processed geometry stream data includes the shearing point data. Since processing manners in case of including the shearing point data are different from processing manners in case of not including the shearing point data, it needs to make a determination first.

In response to the to-be-processed geometry stream data not including the shearing point data, in operation S203, target data to be split in a current batch is acquired from the to-be-processed geometry stream data, here the target data is at least a part of the to-be-processed geometry stream data.

In this operation, since no shearing point is present, various point data from the to-be-processed geometry stream data constitute the topology of the to-be-processed geometry stream data together. Therefore, when the to-be-processed geometry stream data is acquired, it is unnecessary to acquire all the to-be-processed geometry stream data due to uncertainty caused by a number and position of shearing points, instead, only a part of the to-be-processed geometry stream data may be acquired to be split. For example, if the topology of the to-be-processed geometry stream data is a triangle list, any 3*Q point data may be acquired only as the target data to be split in the current batch, here Q is any positive integer, and the 3*Q point data may be split to obtain Q triangle data necessarily. Furthermore, the target data to be split in the current batch may be that a storage address thereof is determined by calculating by the target geometry pipeline allocation module according to parameter information of the system for processing geometry stream data, and then the target data to be split in the current batch is acquired according to the storage address, or may be directly determined according to the storage address of the target data to be split in the current batch provided by an application, and the storage address may be included in the foregoing data processing request. That is, a calculation process of the storage address of the target data to be split in the current batch may occur on the target geometry pipeline, or on the application, or on other functional entities, which is not limited in the disclosure. For the convenience of descriptions, all the following embodiments are described by an example of the process occurring on the target geometry pipeline.

In operation S204, the target data is split into data of corresponding primitive geometries according to the topology of the to-be-processed geometry stream data, to be processed by a geometry pipeline processor in a target geometry pipeline. Here, the target pipeline is a geometry pipeline to which the target pipeline allocation module belongs. In this embodiment, a number of geometry pipeline processors in the target geometry pipeline is not limited, that is, the target geometry pipeline may include one or more geometry pipeline processors. In case that the target geometry pipeline includes multiple geometry pipeline processors, these geometry pipeline processors co-process the data of primitive geometries split by the target geometry pipeline allocation module. In this operation, it is unnecessary for the geometry pipeline allocation module to consider the shearing point data, and the geometry pipeline allocation module may directly split the target data into data of corresponding primitive geometries according to a splitting rule of the topology. Furthermore, it is unnecessary for the geometry pipeline allocation module to split primitive geometries which are not used by the geometry pipeline processor, thereby improving splitting efficiency.

In response to the to-be-processed geometry stream data including the shearing point data, in operation S205, the geometry stream data is processed in other manners. In this embodiment, a situation where the to-be-processed geometry stream data includes the shearing point data is not specifically limited, for example, the geometry stream data may be acquired according to a position of the shearing point.

In the method for processing geometry stream data according to some embodiments of the disclosure, in case that no shearing point is present in the to-be-processed geometry stream data, the geometry pipeline allocation module of each of the geometry pipelines only needs to acquire the target data from the to-be-processed geometry stream data, and split the target data to obtain the data of primitive geometries (data of primitive geometries to be processed by the geometry pipeline in the current batch), instead of having to acquire all the to-be-processed geometry stream data. Therefore, throughput of the geometry pipeline allocation module of each of the geometry pipelines upon acquiring data each time is significantly reduced, and splitting efficiency of the geometry pipeline is greatly improved.

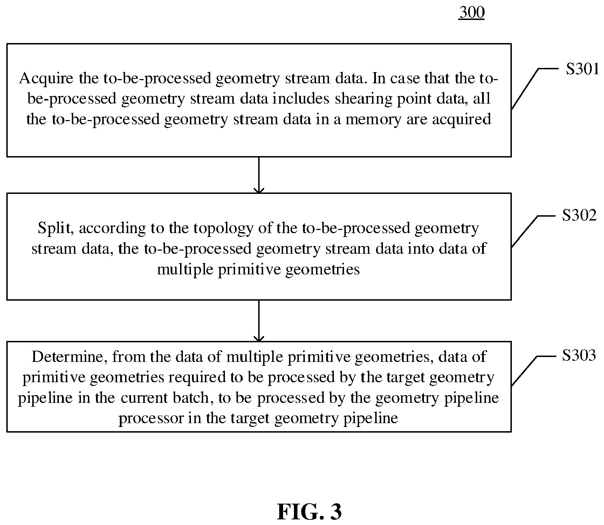

FIG. 3 is a flowchart 300 of a method for processing geometry stream data including shearing point data provided in an embodiment of the disclosure, the method includes the following operations S301 to S303.

In operation S301, the to-be-processed geometry stream data is acquired. In case that the to-be-processed geometry stream data includes shearing point data, all the to-be-processed geometry stream data in a memory are acquired.

In operation S302, the to-be-processed geometry stream data is split into data of multiple primitive geometries according to the topology of the to-be-processed geometry stream data. Since a number and position of the shearing point data are unknown, all the to-be-processed geometry stream data need to be split to determine point data which do not belong to the shearing point data, and these point data are split into data of multiple primitive geometries.

In operation S303, data of primitive geometries to be processed by the target geometry pipeline in the current batch is determined from the data of multiple primitive geometries, to be processed by the geometry pipeline processor in the target geometry pipeline. In this embodiment, a number of geometry pipeline processors in the target geometry pipeline is not limited, that is, the target geometry pipeline may include one or more geometry pipeline processors. In case that the target geometry pipeline includes multiple geometry pipeline processors, these geometry pipeline processors co-process the data of primitive geometries split by the target geometry pipeline allocation module. After the data of all the primitive geometries are obtained, data of corresponding primitive geometries are selected and transmitted to each of the geometry pipeline processors according to the data of primitive geometries to be processed by the geometry pipeline in the current batch. When the data of primitive geometries to be processed by the target geometry pipeline in the current batch are determined, the data may be determined according to a sequence number of the target geometry pipeline to which the target geometry pipeline allocation module belongs, a number of multiple geometry pipelines, and a number of primitive geometries to be processed by each of the geometry pipelines per batch. For example, if there are 4 geometry pipelines, the number of primitive geometries to be processed by each of the geometry pipelines per batch is 10, and the sequence number of the target geometry pipeline to which the target geometry pipeline allocation module belongs is 2, then after the target geometry pipeline allocation module obtains the data of multiple primitive geometries from splitting, the target geometry pipeline allocation module may determine that data of the 11^{th} to 20^{th} primitive geometries are the data of primitive geometries to be processed by the target geometry pipeline in the current batch.

As described above, operations S301 to S303 attached to this embodiment may be used as a specific process of operation S205 in the flowchart shown in FIG. 2. Such system for processing geometry stream data may efficiently process all types of geometry stream data and has a significant advantage for the geometry stream data which do not include the shearing point data.

In some embodiments, when the target data to be split in the current batch is acquired from the to-be-processed geometry stream data in operation S203, the following operations may be included.

First, a sequence number of the target geometry pipeline to which the target geometry pipeline allocation module belongs, a number of multiple geometry pipelines, and a number of primitive geometries to be processed by each of the geometry pipelines per batch are determined. In this embodiment, multiple geometry pipelines process the same to-be-processed geometry stream data, and each of the geometry pipelines operates independently. In order to prevent conflict, a regular operation order should be followed, for example, repeated splitting of the to-be-processed geometry stream data and obtaining too much data of primitive geometries are prevented. Here, it may be ensured that the target geometry pipeline processes only an appropriate number of point data in the to-be-processed geometry stream data without any conflict, at least according to three factors, i.e., the sequence number of the target geometry pipeline to which the target geometry pipeline allocation module belongs, the number of multiple geometry pipelines, and the number of primitive geometries to be processed by each of the geometry pipelines per batch.

Then, the target data to be split in the current batch is acquired from the to-be-processed geometry stream data according to the sequence number of the target geometry pipeline to which the target geometry pipeline allocation module belongs, the number of multiple geometry pipelines, the number of primitive geometries to be processed by each of the geometry pipelines per batch, and the topology of the to-be-processed geometry stream data.

A relative ordinal number of primitive geometries to be processed by a target geometry pipeline processor may be determined according to the sequence number of the target geometry pipeline to which the target geometry pipeline allocation module belongs and the number of primitive geometries to be processed by each of the geometry pipelines per batch. For example, if the sequence number of the target geometry pipeline is 2, and 10 primitive geometries are required to be processed by each of the geometry pipelines per batch, then compared to the target geometry pipeline with a sequence number of 1, primitive geometries to be processed by the target pipeline processor are the 11^{th} to 20^{th} primitive geometries.

A total amount of primitive geometries obtained in case that multiple geometry pipelines included in the system for processing geometry stream data co-process a batch of geometry stream data may be determined according to the number of multiple geometry pipelines and the number of primitive geometries to be processed by each of the geometry pipelines per batch. The target geometry pipeline allocation module may determine an ordinal number of primitive geometries to be obtained from splitting in a next batch, according to the total amount. For example, the system for processing geometry stream data includes 4 geometry pipelines of which each processes 10 primitive geometries, then the total amount is 40. If the sequence number of the target geometry pipeline is 2, a second batch of primitive geometries to be split by the target pipeline processor are the 51^{st} to 60^{th} primitive geometries. Therefore, the target geometry pipeline allocation module may acquire only a part of the geometry stream data corresponding to the 51^{st} to 60^{th} primitive geometries. In this way, the target geometry pipeline allocation module may determine and split the target data batch by batch according to these three factors, and continuously circularly perform as such, until the to-be-processed geometry stream data is processed.

In this embodiment, it is unnecessary for the target geometry pipeline allocation module to acquire the target data to be processed according to a clear instruction each time, instead, the target geometry pipeline allocation module may calculate the target data to be processed in each batch according to the sequence number of the target geometry pipeline to which the target geometry pipeline allocation module belongs, the number of multiple geometry pipelines, and the number of primitive geometries to be processed by each of the geometry pipelines per batch, thereby achieving complete decentralization and improving splitting efficiency. Furthermore, it is unnecessary for the geometry pipeline allocation module to acquire data which is not used by the geometry pipeline processor of the geometry pipeline, which significantly reduces throughput when the geometry stream data is acquired.

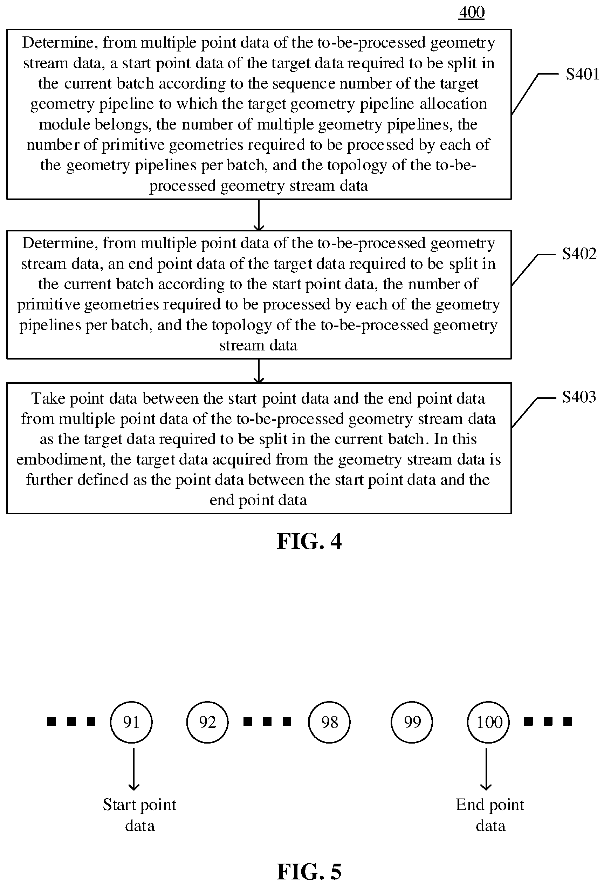

FIG. 4 is a flowchart 400 of a method for processing geometry stream data provided in an embodiment of the disclosure. In this embodiment, the operation of acquiring, from the to-be-processed geometry stream data, the target data to be split in the current batch according to the sequence number of the target geometry pipeline to which the target geometry pipeline allocation module belongs, the number of multiple geometry pipelines, the number of primitive geometries to be processed by each of the geometry pipelines per batch, and the topology of the to-be-processed geometry stream data includes the following operations S401 to S403.

In operation S401, a start point data of the target data to be split in the current batch is determined from multiple point data of the to-be-processed geometry stream data according to the sequence number of the target geometry pipeline to which the target geometry pipeline allocation module belongs, the number of multiple geometry pipelines, the number of primitive geometries to be processed by each of the geometry pipelines per batch, and the topology of the to-be-processed geometry stream data. Since the geometry stream data is composed of a series of point data, these point data may be used to represent the topology of the geometry stream data, and the geometry pipeline allocation module splits these point data into data of primitive geometries, then if the target data to be split in the current batch will be acquired, it needs to determine which point data to be used as a start point of the target data to be split in the current batch.

In operation S402, an end point data of the target data to be split in the current batch is determined from multiple point data of the to-be-processed geometry stream data according to the start point data, the number of primitive geometries to be processed by each of the geometry pipelines per batch, and the topology of the to-be-processed geometry stream data. Similar to determination of the start point data of the target data to be split in the current batch, if the target data to be split in the current batch will be acquired, it needs to determine which point data to be used as an end point of the target data to be split in the current batch.

In operation S403, point data between the start point data and the end point data from multiple point data of the to-be-processed geometry stream data are taken as the target data to be split in the current batch. In this embodiment, the target data acquired from the geometry stream data is further defined as the point data between the start point data and the end point data. It may be seen that in these embodiments of the method for processing geometry stream data, any redundant point data is not required, any required point data is not omitted, and the acquired point data just corresponds to a number of primitive geometries to be processed by the target geometry pipeline in the current batch, which minimizes throughput of acquiring the geometry stream data.

In some embodiments, the operation of determining, from multiple point data of the to-be-processed geometry stream data, the start point data of the target data to be split in the current batch according to the sequence number of the target geometry pipeline to which the target geometry pipeline allocation module belongs, the number of multiple geometry pipelines, the number of primitive geometries to be processed by each of the geometry pipelines per batch, and the topology of the to-be-processed geometry stream data includes the following operations. First, an ordinal number of a first primitive geometry in all primitive geometries of the to-be-processed geometry stream data is determined according to the number of multiple geometry pipelines, the sequence number of the target geometry pipeline to which the target geometry pipeline allocation module belongs, and the number of primitive geometries to be processed by each of the geometry pipelines per batch, here the first primitive geometry is a first primitive geometry from primitive geometries to be processed by the target geometry pipeline in the current batch. Then, the start point data of the target data to be split in the current batch is determined from multiple point data of the to-be-processed geometry stream data according to the ordinal number and the topology of the to-be-processed geometry stream data.

The geometry pipeline allocation module splits the geometry stream data for the geometry pipeline processor, therefore when the target data is determined, it should be based on a processing number of the geometry pipeline processor in the geometry pipeline. Furthermore, a processing object of the geometry pipeline processor is data of primitive geometries, therefore it needs to predetermine a start ordinal number and an end ordinal number of the data of primitive geometries which should be processed by the geometry pipeline processor in the geometry pipeline in the current batch of processing, and to determine the target data on this basis, that is, determine the start point data and the end point data of the target data to be split in the current batch. In this way, it may be further ensured that the acquired point data just corresponds to a number of primitive geometries to be processed by the geometry pipeline in the current batch, which minimizes throughput of acquiring the geometry stream data.

In some embodiments, the operation of determining the ordinal number of the first primitive geometry in all primitive geometries of the to-be-processed geometry stream data, according to the number of multiple geometry pipelines, the sequence number of the target geometry pipeline to which the target geometry pipeline allocation module belongs, and the number of primitive geometries to be processed by each of the geometry pipelines per batch includes the following operations.

The ordinal number is determined according to a following formula (1): $q = \left(a-1\right) * n + 1 + n * m * b$ formula (1),
here q is the ordinal number, m is the number of multiple geometry pipelines and m is a positive integer greater than 1, a is the sequence number of the target geometry pipeline to which the target geometry pipeline allocation module belongs and a is greater than 0 and less than or equal to m, n is the number of primitive geometries to be processed by each of the geometry pipelines per batch and n is a positive integer, b is a number of batches which have been processed by the target geometry pipeline allocation module and b is a non-negative number.

For example, when the sequence number of the target geometry pipeline to which the target geometry pipeline allocation module belongs is 2 and the number of primitive geometries to be processed by each of the geometry pipelines per batch is 10, the target geometry pipeline allocation module has processed two batches of target data, the system for processing geometry stream data includes a total of 4 geometry pipelines, then in a third batch of target data, the ordinal number of the first primitive geometry in all primitive geometries of the to-be-processed geometry stream data is (2-1)*10+1+10*4*2=91, i.e., the 91^{st} primitive geometry in the to-be-processed geometry stream data. In this embodiment, each of the geometry pipeline allocation modules may calculate a position of the start point data of the target data to be split in the current batch according to the ordinal number and the topology of the to-be-processed geometry stream data, thereby acquiring the target data to be split in the current batch without acquiring all the geometry stream data.

However, different geometry pipelines may have different topologies, and different topologies correspond to different point data, that is, different topologies have different point data arrangement rules. Therefore, after the ordinal number of the first primitive geometry in all primitive geometries of the to-be-processed geometry stream data is determined, it still needs to determine the start point data and the end point data of the target data to be split in the current batch according to the topology of the geometry pipeline. Manners of determining the start point data and the end point data of the target data to be split in the current batch will be explained in detail below with respect to different topological types. In the following embodiments, letters q, a, n, m and b have the same meanings as those in the above embodiments, and descriptions thereof are not repeated for the sake of simplicity.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a point list, a q-th point data from multiple point data of the to-be-processed geometry stream data is taken as the start point data. Since the data of primitive geometries obtained by splitting the geometry stream data having a point list topology is geometry point data, and one point data is required to constitute one geometry point data, then it may be determined, according to these characteristics of the point list topology, that the start point data of the target data to be split in the current batch is the q-th point data from the geometry stream data, and the point data may be directly split into one geometry point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (q+n-1)-th point data from multiple point data of the to-be-processed geometry stream data is taken as the end point data. Since one point data is required to constitute one geometry point data, then in case that the target geometry pipeline processor needs to process n geometry point data per batch, the position of the end point data is increased by n-1 based on the position of the start point data.

After acquiring the target data to be split in the current batch, the target geometry pipeline allocation module splits the q-th to (q+n-1)-th point data into geometry point data according to a splitting rule of the geometry point data.

FIG. 5 is a schematic diagram of acquiring target data from geometry stream data having a point list topology in a method for processing geometry stream data provided in an embodiment of the disclosure, here points are arranged on a line, each of the points represents a point data from the geometry stream data, and a sequence number of the point data represents a sequence number of the point data in all point data of the entire geometry stream data. When a=2, m=4, n=10 and b=2, q=91, that is, primitive geometries to be processed by the target geometry pipeline allocation module are primitive geometries with ordinal numbers of 91 to 100 from all the primitive geometries of the to-be-processed geometry stream data. In this case, the start point data is the 91^{st} point data, and the end point data is the (91+10-1)-th=100^{th} point data. The geometry pipeline allocation module of the target geometry pipeline may acquire only the 91^{st} to 100^{th} point data and split the point data into geometry point data, and then transmit the geometry point data to the geometry pipeline processor to process the geometry point data.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a line list, a (2*q-1)-th point data from multiple point data of the to-be-processed geometry stream data is taken as the start point data. Since the data of primitive geometries obtained by splitting the geometry stream data having a line list topology is line data, and two point data are required to constitute one line data, then it may be determined, according to these characteristics of the line list topology, that the start point data of the target data to be split in the current batch is the (2*q-1)-th point data from the geometry stream data, and the point data may be split into one line data together with the (2*q)-th point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (2*q+2*n-2)-th point data from multiple point data of the to-be-processed geometry stream data is taken as the end point data. Since two point data are required to constitute one line data, then in case that the target geometry pipeline processor needs to process n line data per batch, the position of the end point data is increased by 2*n-1 based on the position of the start point data.

After acquiring the target data, the target geometry pipeline allocation module splits the (2*q-1)-th to (2*q+2*n-2)-th point data into line data according to a splitting rule of the line data.

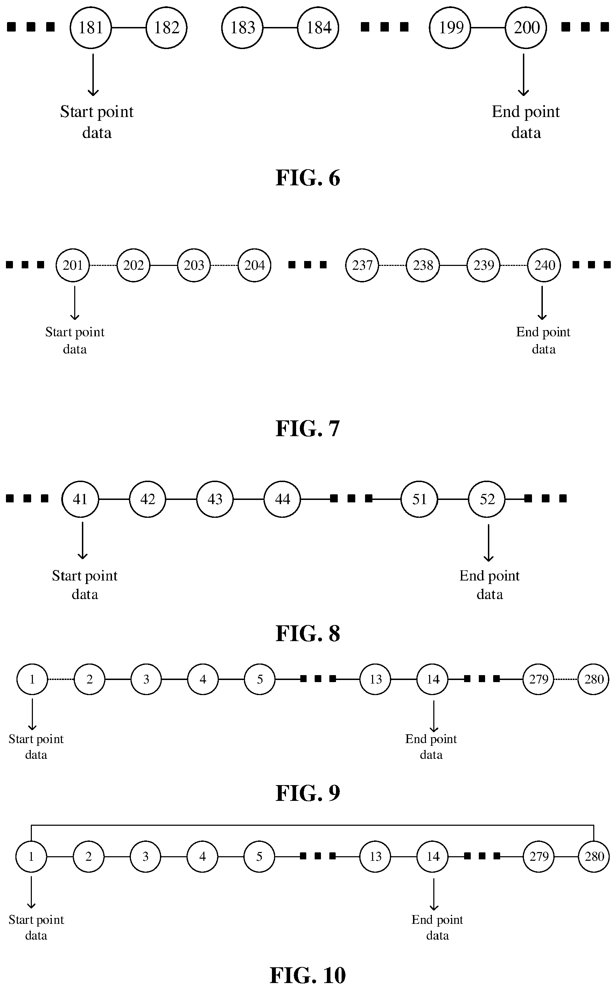

FIG. 6 is a schematic diagram of acquiring target data from geometry stream data having a line list topology in a method for processing geometry stream data provided in an embodiment of the disclosure. The line list topology may be a topology as shown in FIG. 6, here multiple line segments formed by points are arranged on a line, each of the points represents a point data from the geometry stream data, and a sequence number of the point data represents a sequence number of the point data in all point data of the entire geometry stream data. When a=2, m=4, n=10 and b=2, q=91, that is, primitive geometries to be processed by the target geometry pipeline allocation module are primitive geometries with ordinal numbers of 91 to 100 from all the primitive geometries of the to-be-processed geometry stream data. In this case, the start point data is the (91*2-1)-th=181^{st} point data, and the end point data is the (91*2+2*10-2)-th=200^{th} point data. The geometry pipeline allocation module of the target geometry pipeline may acquire only the 181^{st} to 200^{th} point data and split the point data into line data, and then transmit the line data to the geometry pipeline processor to process the line data.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a line list with adjacency information, a (4*q-3)-th point data from multiple point data of the to-be-processed geometry stream data is taken as the start point data. Since the data of primitive geometries obtained by splitting the geometry stream data having a line list topology with adjacency information is line data with adjacency information, and four point data are required to constitute one line data with adjacency information, then it may be determined, according to these characteristics of the line list topology with adjacency information, that the start point data of the target data to be split in the current batch is the (4*q-3)-th point data from the geometry stream data, and the point data may be split into one line data with adjacency information together with the (4*q-2)-th point data, the (4*q-1)-th point data and the (4*q)-th point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (4*q+4*n-4)-th point data from multiple point data of the to-be-processed geometry stream data is taken as the end point data. Since four point data are required to constitute one line data with adjacency information, then in case that the target geometry pipeline processor needs to process n line data with adjacency information per batch, the position of the end point data is increased by 4*n-1 based on the position of the start point data.

After acquiring the target data, the target geometry pipeline allocation module splits the (4*q-3)-th to (4*q+4*n-4)-th point data into line data with adjacency information according to a splitting rule of the line data with adjacency information.

FIG. 7 is a schematic diagram of acquiring target data from geometry stream data having a line list topology with adjacency information in a method for processing geometry stream data provided in an embodiment of the disclosure. The line list topology with adjacency information may be a topology as shown in FIG. 7, here multiple line segments with adjacency information formed by points are arranged on a line, each of the points represents a point data from the geometry stream data, and a sequence number of the point data represents a sequence number of the point data in all point data of the entire geometry stream data. When a=2, m=4, n=10 and b=1, q=51, that is, primitive geometries to be processed by the target geometry pipeline allocation module are primitive geometries with ordinal numbers of 51 to 60 from all the primitive geometries of the to-be-processed geometry stream data. In this case, the start point data is the (51*4-3)-th=201^{st} point data, and the end point data is the (51*4+4*10-4)-th=240^{th} point data. The geometry pipeline allocation module of the target geometry pipeline may acquire only the 201^{st} to 240^{th} point data and split the point data into line data with adjacency information, and then transmit the line data with adjacency information to the geometry pipeline processor to process the line data with adjacency information.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a line strip, a q-th point data from multiple point data of the to-be-processed geometry stream data is taken as the start point data. Since the data of primitive geometries obtained by splitting the geometry stream data having a line strip topology is line data, two point data are required to constitute one line data, and a common point data is present between two adjacent line data in the line strip topology, then it may be determined, according to these characteristics of the line strip topology, that the start point data of the target data to be split in the current batch is the q-th point data from the geometry stream data, and the point data may be split into one line data together with the (q+1)-th point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (q+n+1)-th point data from multiple point data of the to-be-processed geometry stream data is taken as the end point data. Since two point data are required to constitute one line data, and a common point data is present between two adjacent line data in the line strip topology, then in case that the target geometry pipeline processor needs to process n line data per batch, the position of the end point data is increased by n+1 based on the position of the start point data.

After acquiring the target data, the target geometry pipeline allocation module splits the q-th to (q+n+1)-th point data into line data according to a splitting rule of the line strip topology.

FIG. 8 is a schematic diagram of acquiring target data from geometry stream data having a line strip topology in a method for processing geometry stream data provided in an embodiment of the disclosure. The line strip topology may be a topology as shown in FIG. 8, here multiple line segments formed by points are arranged on a line, a common end point is present between two adjacent line segments, each of the points represents a point data from the geometry stream data, and a sequence number of the point data represents a sequence number of the point data in all point data of the entire geometry stream data. When a=1, m=4, n=10 and b=1, q=41, that is, primitive geometries to be processed by the target geometry pipeline allocation module are primitive geometries with ordinal numbers of 41 to 50 from all the primitive geometries of the to-be-processed geometry stream data. In this case, the start point data is the 41^{st} point data, and the end point data is the (41+10+1)-th=52^{nd} point data. The geometry pipeline allocation module of the target geometry pipeline may acquire only the 41^{st} to 52^{nd} point data and split the point data into line data, and then transmit the line data to the geometry pipeline processor to process the line data.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a line strip with adjacency information, a q-th point data from multiple point data of the to-be-processed geometry stream data is taken as the start point data. Since the data of primitive geometries obtained by splitting the geometry stream data having a line strip topology with adjacency information is line data with adjacency information, four point data are required to constitute one line data with adjacency information, and in the line strip topology with adjacency information, adjacency information of the second point data is the first point data, adjacency information of the last but one point data is the last point data, and three common point data are present between two adjacent line data with adjacency information, then it may be determined, according to these characteristics of the line strip topology with adjacency information, that the start point data of the target data to be split in the current batch is the q-th point data from the geometry stream data, and the point data may be split into one line data with adjacency information together with the (q+1)-th point data, the (q+2)-th point data and the (q+3)-th point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (q+n+3)-th point data from multiple point data of the to-be-processed geometry stream data is taken as the end point data. Since four point data are required to constitute one line data with adjacency information, and three common point data are present between two adjacent line data with adjacency information in the line strip topology with adjacency information, then in case that the target geometry pipeline processor needs to process n line data with adjacency information per batch, the position of the end point data is increased by n+3 based on the position of the start point data.

After acquiring the target data, the target geometry pipeline allocation module splits the q-th to (q+n+3)-th point data into line data with adjacency information according to a splitting rule of the line strip topology with adjacency information.

FIG. 9 is a schematic diagram of acquiring target data from geometry stream data having a line strip topology with adjacency information in a method for processing geometry stream data provided in an embodiment of the disclosure. The line strip topology with adjacency information may be a topology as shown in FIG. 9 and includes 280 points, here adjacency information of the second point is the first point, adjacency information of the last but one point is the last point, three common point data are present between two adjacent line segments with adjacency information, and a sequence number of the point data represents a sequence number of the point data in all point data of the entire geometry stream data. When a=1, m=4, n=10 and b=0, q=1, that is, primitive geometries to be processed by the target geometry pipeline allocation module are primitive geometries with ordinal numbers of 1 to 10 from all the primitive geometries of the to-be-processed geometry stream data. In this case, the start point data is the 1^{st} point data, and the end point data is the (1+10+3)-th=14^{th} point data. The geometry pipeline allocation module of the target geometry pipeline may acquire only the 1^{st} to 14^{th} point data and split the point data into line data with adjacency information, and then transmit the line data with adjacency information to the geometry pipeline processor to process the line data with adjacency information.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a line loop, a q-th point data from multiple point data of the to-be-processed geometry stream data is taken as the start point data. Since the data of primitive geometries obtained by splitting the geometry stream data having a line loop topology is line data, two point data are required to constitute one line data, and in the line loop topology, the last point data is connected to the first point data, and a common point data is present between two adjacent line data, then it may be determined, according to these characteristics of the line loop topology, that the start point data of the target data to be split in the current batch is the q-th point data from the geometry stream data, and the point data may be split into one line data together with the (q+1)-th point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. (a) In response to not requiring the geometry pipeline processor of the target geometry pipeline to process a last line data from all line data of the to-be-processed geometry stream data, a (q+n+1)-th point data from multiple point data of the to-be-processed geometry stream data is taken as the end point data. (b) In response to requiring the geometry pipeline processor of the target geometry pipeline to process the last line data from all line data of the to-be-processed geometry stream data, a first point data is taken as the end point data. Since two point data are required to constitute one line data, and a common point data is present between two adjacent line data in the line loop topology, then in case that the target geometry pipeline needs to process n line data in the current batch and the n line data do not include the last line data from all line data of the to-be-processed geometry stream data, the position of the end point data is increased by n+1 based on the position of the start point data; in case that the target geometry pipeline needs to process n line data in the current batch and the n line data include the last line data from all line data of the to-be-processed geometry stream data, the end point data is the first point data.

After acquiring the target data, the target geometry pipeline allocation module splits the q-th to (q+n+1)-th point data into line data with adjacency information according to a splitting rule of the line loop. For example, the to-be-processed geometry stream data has 100 point data, the 91^{st} point data is the start point data, the target geometry pipeline needs to process 10 line data in the current batch, and the 10 line data include the last line data from all line data of the to-be-processed geometry stream data, then the target data is point data between the 91^{st} point data and the 100^{th} point data plus the first point data, i.e., a total of 11 point data, here the 100^{th} point data and the first point data may be split into one line data.

FIG. 10 is a schematic diagram of acquiring target data from geometry stream data having a line loop topology in a method for processing geometry stream data provided in an embodiment of the disclosure. The line loop topology may be a topology as shown in FIG. 10 and includes a total of 280 points, here multiple line segments formed by points are arranged on a line, the first point is connected to the last point, each of the points represents a point data from the geometry stream data, and a sequence number of the point data represents a sequence number of the point data in all point data of the entire geometry stream data. When a=0, m=4, n=10 and b=0, q=1, that is, primitive geometries to be processed by the target geometry pipeline allocation module are primitive geometries with ordinal numbers of 1 to 10 from all the primitive geometries of the to-be-processed geometry stream data. In this case, the start point data is the 1^{st} point data, and the end point data is the (1+10-1+1)-th=11^{st} point data. The geometry pipeline allocation module of the target geometry pipeline may acquire only the 1^{st} to 11^{st} point data and split the point data into line data, and then transmit the line data to the geometry pipeline processor to process the line data.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a triangle list, a (3*q-2)-th point data from multiple point data of the to-be-processed geometry stream data is taken as the start point data. Since the data of primitive geometries obtained by splitting the geometry stream data having a triangle list topology is triangle data, three point data are required to constitute one triangle data, and no common point data is present between two adjacent triangle data in the triangle list topology, then it may be determined, according to these characteristics of the triangle list topology, that the start point data of the target data to be split in the current batch is the (3*q-2)-th point data from the geometry stream data, and the point data may be split into one triangle data together with the (3*q-1)-th point data and the (3*q)-th point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (3*q+3*n-3)-th point data from multiple point data of the to-be-processed geometry stream data is taken as the end point data. Since three point data are required to constitute one triangle data, and no common point data is present between two adjacent triangle data in the triangle list topology, then in case that the target geometry pipeline needs to process n triangle data in the current batch, the position of the end point data is increased by 3*n-1 based on the position of the start point data.

After acquiring the target data, the target geometry pipeline allocation module splits the (3*q-2)-th to (3*q+3*n-3)-th point data into triangle data according to a splitting rule of the line strip with adjacency information.

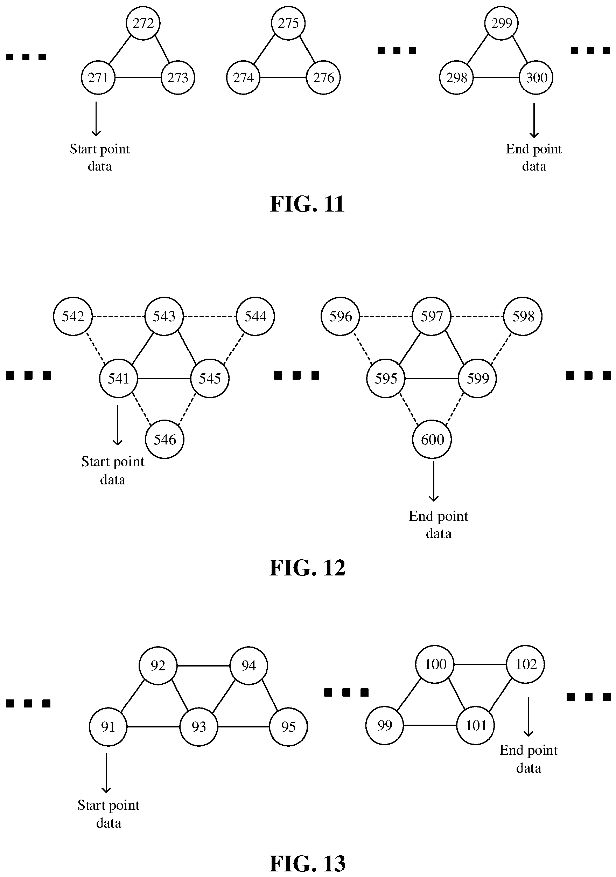

FIG. 11 is a schematic diagram of acquiring target data from geometry stream data having a triangle list topology in a method for processing geometry stream data provided in an embodiment of the disclosure. The triangle list topology may be a topology as shown in FIG. 11, here multiple triangles formed by points are arranged on a line, each of the points represents a point data from the geometry stream data, and a sequence number of the point data represents a sequence number of the point data in all point data of the entire geometry stream data. When a=2, m=4, n=10 and b=2, q=91, that is, primitive geometries to be processed by the target geometry pipeline allocation module are primitive geometries with ordinal numbers of 91 to 100 from all the primitive geometries of the to-be-processed geometry stream data. In this case, the start point data is the (91*3-2)-th=271^{st} point data, and the end point data is the (271+10*3-1)-th=300^{th} point data. The geometry pipeline allocation module of the target geometry pipeline may acquire only the 271^{st} to 300^{th} point data and split the point data into triangle data, and then transmit the triangle data to the geometry pipeline processor to process the triangle data.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a triangle list topology with adjacency information, a (6*q-5)-th point data from multiple point data of the to-be-processed geometry stream data is taken as the start point data. Since the data of primitive geometries obtained by splitting the geometry stream data having a triangle list topology with adjacency information is triangle data with adjacency information, six point data are required to constitute one triangle data with adjacency information, and no common point data is present between two adjacent triangle data with adjacency information in the triangle list topology with adjacency information, then it may be determined, according to these characteristics of the triangle list topology with adjacency information, that the start point data of the target data to be split in the current batch is the (6*q-5)-th point data from the geometry stream data, and the point data may be split into one triangle data with adjacency information together with the (6*q-4)-th point data, the (6*q-3)-th point data, the (6*q-2)-th point data, the (6*q-1)-th point data and the (6*q)-th point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (6*q+6*n-6)-th point data from multiple point data of the to-be-processed geometry stream data is taken as the end point data. Since six point data are required to constitute one triangle data with adjacency information, and no common point data is present between two adjacent triangle data with adjacency information in the triangle list topology with adjacency information, then in case that the target geometry pipeline needs to process n triangle data with adjacency information in the current batch, the position of the end point data is increased by 6*n-1 based on the position of the start point data.

After acquiring the target data, the target geometry pipeline allocation module splits the (6*q-5)-th to (6*q+6*n-6)-th point data into triangle data with adjacency information according to a splitting rule of the triangle list topology with adjacency information.

FIG. 12 is a schematic diagram of acquiring target data from geometry stream data having a triangle list topology with adjacency information in a method for processing geometry stream data provided in an embodiment of the disclosure. The triangle list topology with adjacency information may be a topology as shown in FIG. 12, here multiple triangles with adjacency information formed by points are arranged on a line, each of the points represents a point data from the geometry stream data, and a sequence number of the point data represents a sequence number of the point data in all point data of the entire geometry stream data. When a=2, m=4, n=10 and b=2, q=91, that is, primitive geometries to be processed by the target geometry pipeline allocation module are primitive geometries with ordinal numbers of 91 to 100 from all the primitive geometries of the to-be-processed geometry stream data. In this case, the start point data is the (91*6-5)-th=541^{st} point data, and the end point data is the (541+10*6-1)-th=600^{th} point data. The geometry pipeline allocation module of the target geometry pipeline may acquire only the 541^{st} to 600^{th} point data and split the point data into triangle data with adjacency information, and then transmit the triangle data with adjacency information to the geometry pipeline processor to process the triangle data with adjacency information.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a triangle strip, a q-th point data from multiple point data of the to-be-processed geometry stream data is taken as the start point data. Since the data of primitive geometries obtained by splitting the geometry stream data having a triangle strip topology is triangle data, three point data are required to constitute one triangle data, and two common point data are present between two adjacent triangle data in the triangle strip topology, then it may be determined, according to these characteristics of the triangle strip topology, that the start point data of the target data to be split in the current batch is the q-th point data from the geometry stream data, and the point data may be split into one triangle data together with the (q+1)-th point data and the (q+2)-th point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (q+n+1)-th point data from multiple point data of the to-be-processed geometry stream data is taken as the end point data. Since three point data are required to constitute one triangle data, and two common point data are present between two adjacent triangle data in the triangle strip topology, then in case that the target geometry pipeline processor needs to process n triangle data per batch, the position of the end point data is increased by n+1 based on the position of the start point data.

The q-th to (q+n+1)-th point data are split into triangle data according to a splitting rule of the triangle strip topology.

FIG. 13 is a schematic diagram of acquiring target data from geometry stream data having a triangle strip topology in a method for processing geometry stream data provided in an embodiment of the disclosure. The triangle strip topology may be a topology as shown in FIG. 13, here multiple triangles formed by points are arranged on a line, each of the points represents a point data from the geometry stream data, and a sequence number of the point data represents a sequence number of the point data in all point data of the entire geometry stream data. When a=2, m=4, n=10 and b=2, q=91, that is, primitive geometries to be processed by the target geometry pipeline allocation module are primitive geometries with ordinal numbers of 91 to 100 from all the primitive geometries of the to-be-processed geometry stream data. In this case, the start point data is the 91^{st} point data, and the end point data is the (91+10+1)-th=102^{nd} point data. The geometry pipeline allocation module of the target geometry pipeline may acquire only the 91^{st} to 102^{nd} point data and split the point data into triangle data, and then transmit the triangle data to the geometry pipeline processor to process the triangle data.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. (a) In response to the topology of the to-be-processed geometry stream data being a triangle strip with adjacency information and q being equal to 1, a first point data from multiple point data of the to-be-processed geometry stream data is taken as the start point data. (b) In response to the topology of the to-be-processed geometry stream data being the triangle strip with adjacency information and q being greater than 1, a (2*q-4)-th point data from multiple point data of the to-be-processed geometry stream data is taken as the start point data. Since the data of primitive geometries obtained by splitting the geometry stream data having a triangle topology with adjacency information is triangle data with adjacency information, seven point data are required to constitute one triangle data with adjacency information, and five common point data are present between two adjacent triangle data with adjacency information in the triangle strip topology with adjacency information, then according to these characteristics of the triangle strip topology with adjacency information, if the target geometry pipeline allocation module needs to split a first triangle data with adjacency information from a geometry stream data flow, it may be determined that the start point data of the target data to be split in the current batch is the first point data from the geometry stream data, and the point data may be split into one triangle data with adjacency information together with the second to seventh point data. Otherwise, the start point data is the (2*q-4)-th point data from the geometry stream data, and the point data may be split into one triangle data with adjacency information together with the (2*q-3)-th point data, the (2*q-2)-th point data, the (2*q-1)-th point data, the (2*q)-th point data, the (2*q-4+1)-th point data and the (2*q-4+2)-th point data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. In response to q being equal to 1, a (2*n+7)-th point data from multiple point data of the to-be-processed geometry stream data is taken as the end point data. Or, in response to q being greater than 1, a (2*q-4+2n+8)-th point data from multiple point data of the to-be-processed geometry stream data is taken as the end point data. Since seven point data are required to constitute one triangle data with adjacency information, and five common point data are present between two adjacent triangle data in the triangle strip, then in case that the target geometry pipeline processor needs to process n triangle data with adjacency information per batch, if the target geometry pipeline allocation module needs to split the first triangle data with adjacency information from the geometry stream data flow, the position of the end point data is increased by 2*n+6 based on the position of the start point data; otherwise, the position of the end point data is increased by 2*n+8 based on the position of the start point data.

According to a splitting rule of the triangle strip topology with adjacency information, if the target geometry pipeline allocation module needs to split the first triangle data with adjacency information from the geometry stream data flow, the first to (2*n+7)-th point data are split into triangle data with adjacency information; otherwise, the (2*q-4)-th to (2*q-4+2n+8)-th point data are split into triangle data with adjacency information.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a control package list with k points, a (k*q-k+1)-th point data from multiple point data of the to-be-processed geometry stream data is taken as the start point data, here k is a positive integer. Since the data of primitive geometries obtained by splitting the geometry stream data having a control package list topology with k points is data of primitive geometries including k points, the data of primitive geometries is geometry point data when k=1, the data of primitive geometries is line data when k=2, the data of primitive geometries is triangle data when k=3, and the data of primitive geometries is customized data of primitive geometries when k>3, and k point data are required to constitute one data of primitive geometries including k points, and no common point data is present between two adjacent data of primitive geometries including k points in the control package list topology with k points, then it may be determined, according to these characteristics of the control package list topology with k points, that the start point data of the target data to be split in the current batch is the (k*q-k+1)-th point data from the geometry stream data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (k*q+k*n-n)-th point data from multiple point data of the to-be-processed geometry stream data is taken as the end point data. Since k point data are required to constitute one data of primitive geometries including k points, and no common point data is present between two adjacent data of primitive geometries including k points in the control package list topology with k points, then in case that the target geometry pipeline processor needs to process n data of primitive geometries including k points per batch, the position of the end point data is increased by (k*n-n+k-1) based on the position of the start point data.

According to a splitting rule of the control package list topology with k points, the (k*q-k+1)-th to (k*q+k*n-n)-th point data are split into data of primitive geometries including k points.

The above embodiments provide exemplary implementations for various geometry stream data in the field of graphics processing respectively, of which all may significantly improve processing efficiency and achieve decentralization of geometry pipelines.

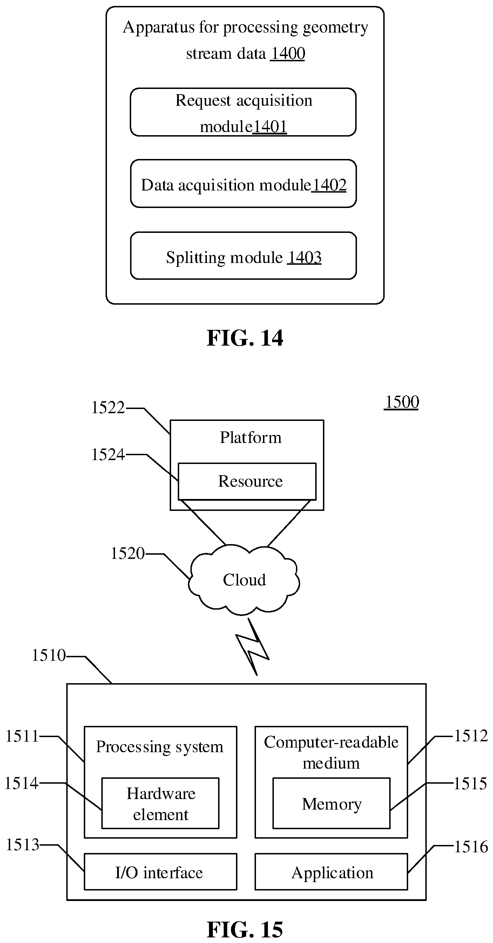

FIG. 14 is an exemplary structural block diagram of an apparatus for processing geometry stream data 1400 provided in an embodiment of the disclosure. The apparatus for processing geometry stream data is one of multiple apparatuses for processing geometry stream data included in a system for processing geometry stream data, the system for processing geometry stream data includes multiple geometry pipelines of which each includes an apparatus for processing geometry stream data and a geometry pipeline processor. The apparatus for processing geometry stream data 1400 includes a request acquisition module 1401, a data acquisition module 1402, and a splitting module 1403. The request acquisition module 1401 is configured to acquire a data processing request, here the data processing request indicates a topology of a to-be-processed geometry stream data and whether the to-be-processed geometry stream data includes shearing point data, and the shearing point data indicates that no common vertex is present between a topology where a previous point data of the shearing point data is located and a topology where a next point data of the shearing point data is located. The data acquisition module 1402 is configured to acquire, from the to-be-processed geometry stream data, target data to be split in a current batch in response to the to-be-processed geometry stream data not including the shearing point data, here the target data is at least a part of the to-be-processed geometry stream data. The splitting module 1403 is configured to split, according to the topology of the to-be-processed geometry stream data, the target data into data of corresponding primitive geometries to be processed by a geometry pipeline processor in a target geometry pipeline, here the target pipeline is a geometry pipeline to which the target pipeline allocation module belongs.

It should be noted that the above various modules may be implemented in software or hardware or a combination of software and hardware. Multiple different modules may be implemented in the same software or hardware structure, or one module may be implemented by multiple different software or hardware structures.

In the apparatus for processing geometry stream data according to some embodiments of the disclosure, in case that no shearing point is present in the to-be-processed geometry stream data, the geometry pipeline allocation module of each of the geometry pipelines only needs to acquire the target data from the to-be-processed geometry stream data, and split the target data to obtain the data of primitive geometries (data of primitive geometries to be processed by the geometry pipeline in the current batch), instead of having to acquire all the to-be-processed geometry stream data. Therefore, throughput of the geometry pipeline allocation module of each of the geometry pipelines upon acquiring data each time is significantly reduced, and splitting efficiency of the geometry pipeline is greatly improved.

FIG. 15 illustrates an exemplary system 1500, the system 1500 includes an exemplary computing device 1510 representing one or more systems and/or devices which may implement various methods described here. For example, the computing device 1510 may be a server of a service provider, a device associated with a server, a system on chip (SoC), and/or any other suitable computing devices or systems. The apparatus for processing geometry stream data 1400 as described above with reference to FIG. 14 may take a form of the computing device 1510. Alternatively, the apparatus for processing geometry stream data 1400 may be implemented as a computer program in form of an application 1516.

The exemplary computing device 1510 as shown in the figure includes a processing system 1511, one or more computer-readable media 1512, and one or more input/output (I/O) interfaces 1513 which are communicatively coupled to each other. Although not shown, the computing device 1510 may further include a system bus or other data and command transmission systems which couple various components to each other. The system bus may include any one or combination of different bus structures such as a memory bus or memory controller, a peripheral bus, a universal serial bus (USB), and/or a processor or local bus utilizing any one of various bus architectures. Various other examples such as control and data lines are also contemplated.

The processing system 1511 represents a function of performing one or more operations by using hardware. Therefore, the processing system 1511 is illustrated as including a hardware element 1514 which may be configured as a processor, a functional block, etc. This may include other logic devices implemented as Application Specific Integrated Circuits (ASICs) in hardware or formed by using one or more semiconductors. The hardware element 1514 is not limited by a material from which it is formed or a processing mechanism used therein. For example, the processor may be composed of (multiple) semiconductors and/or transistors (such as electronic ICs). In such context, processor-executable instructions may be electronic executable instructions.

The computer-readable medium 1512 is illustrated as including a memory/storage device 1515. The memory/storage device 1515 represents a memory/storage capacity associated with one or more computer-readable media. The memory/storage device 1515 may include a volatile medium (such as a Random Access Memory (RAM)) and/or a non-volatile medium (such as a Read-Only Memory (ROM), a flash memory, an optical disk, a magnetic disk, etc.). The memory/storage device 1515 may include a fixed medium (such as RAM, ROM, a fixed Hard Disk Drive (HDD), etc.) and a mobile medium (such as a flash memory, a mobile HDD, an optical disk, etc.). The computer-readable medium 1512 may be configured in various other manners as described below.

One or more I/O interfaces 1513 represent a function which allows a user to input commands and information to the computing device 1510 by using various input devices, and optionally also allows information to be presented to the user and/or other components or devices by using various output devices. Examples of the input devices include a keyboard, a cursor control device (such as a mouse), a microphone (such as, used for inputting voice), a scanner, a touch function (such as a capacitive or other sensors configured to detect physical touches), a camera (for example, it may use a visible or invisible wavelength (such as an infrared frequency) to detect motions which do not involve touches as gestures), etc. Examples of the output devices include a display device, a speaker, a printer, a network card, a tactile response device, etc. Therefore, the computing device 1510 may be configured in various manners as described below, to support user interaction.

The computing device 1510 further includes an application 1516. For example, the application 1516 may be a software instance of the apparatus for processing geometry stream data 1400, and implement technologies described here in combination with other elements in the computing device 1510.

In the disclosure, various technologies may be described in a general context of software and hardware elements or program modules. In general, these modules include routines, programs, objects, elements, components, data structures, or the like which perform a specific task or implement a specific abstract data type. Terms "module", "function" and "component" as used here generally represent software, firmware, hardware or a combination thereof. Characteristics of the technologies described here are independent of platforms, which means that these technologies may be implemented on various computing platforms provided with various processors.

Implementations of the described modules and technologies may be stored on or transmitted across a certain form of computer-readable medium. The computer-readable medium may include various media which may be accessed by the computing device 1510. As an example rather than limitation, the computer-readable medium may include a "computer-readable storage medium" and a "computer-readable signal medium".

In contrast to simple signal transmission, carrier wave or signal itself, the "computer-readable storage medium" refers to a medium and/or device capable of persistently storing information, and/or a tangible storage device. Therefore, the computer-readable storage medium refers to a non-signal carrying medium. The computer-readable storage medium include hardware such as a volatile medium and a non-volatile medium, a mobile medium and a non-mobile medium, and/or a storage device implemented in a method or technology suitable for storing information (such as computer-readable instructions, data structures, program modules, logic elements/circuits, or other data). Examples of the computer-readable storage medium may include, but are not limited to RAM, ROM, an Electrically Erasable Programmable Read-Only Memory (EEPROM), a flash memory or other memory technologies, a Compact Disc Read-Only Memory (CD-ROM), a Digital Versatile Disc (DVD) or other optical storage devices, a hard disk, a cassette, a magnetic tape, a magnetic disk storage device or other magnetic storage devices, or other storage devices, a tangible medium or product suitable for storing desired information and accessible by a computer.

The "computer-readable signal medium" refers to a signal carrying medium which is configured to send instructions to hardware of the computing device 1510, for example through a network. Typically, the signal medium may embody computer-readable instructions, data structures, program modules or other data in a modulated data signal such as a carrier wave, a data signal or other transmission mechanisms. The signal medium further includes any information transfer medium. The term "modulated data signal" refers to a signal of which one or more of characteristics are set or changed to encode information into the signal. As an example rather than limitation, a communication medium includes a wired medium such as a wired network or direct connection, and a wireless medium such as an acoustic medium, a Radio Frequency (RF) medium, an infrared medium and other wireless media.

As described previously, the hardware element 1514 and the computer-readable medium 1512 represent instructions, modules, programmable device logics and/or fixed device logics implemented in form of hardware, which may implement at least some aspects of the technologies described here in some embodiments. The hardware element may include IC or SoC, ASIC, a Field Programmable Gate Array (FPGA), a Complex Programmable Logic Device (CPLD), and other implementations in silicon or components of other hardware devices. In such context, the hardware element may be used as a processing device which performs program tasks defined by instructions, modules and/or logics embodied by the hardware element, and a hardware device configured to store instructions for execution, such as the computer-readable storage medium as described previously.

A combination of the foregoing items may also be used to implement various technologies and modules here. Therefore, the software, hardware or program module and other program modules may be implemented as one or more instructions and/or logics embodied on a certain form of computer-readable storage medium and/or by one or more hardware elements 1514. The computing device 1510 may be configured to implement a specific instruction and/or function corresponding to the software and/or hardware module. Therefore, for example, with usage of the computer-readable storage medium and/or the hardware element 1514 of the processing system, a module may be at least partially implemented in hardware as a module which may be performed by the computing device 1510 as software. The instruction and/or function may be performed/operated by one or more products (such as one or more computing devices 1510 and/or processing systems 1011) to implement the technologies, modules and examples described here.

In various implementations, the computing device 1510 may use various different configurations. For example, the computing device 1510 may be implemented as a computer-type device including a personal computer, a desktop computer, a multi-screen computer, a laptop computer, a netbook, etc. The computing device 1510 may also be implemented as a mobile device-type device including a mobile device such as a mobile phone, a portable music player, a portable game device, a tablet computer, a multi-screen computers, etc. The computing device 1510 may also be implemented as a TV-type device including a device provided with a usually large screen or connected to a usually large screen in a casual viewing environment. These devices include TV, a set-top box, a game console, etc.

The technologies described here may be supported by these various configurations of the computing device 1510, and are not limited to specific examples of the technologies described here. Functions may also be entirely or partially implemented on a "cloud" 1520 by using a distributed system, for example, through a platform 1522 as described below.

The cloud 1520 includes and/or represents the platform 1522 for a resource 1524. The platform 1522 abstracts underlying functions of hardware (such as a server) and software resources of the cloud 1520. The resource 1524 may include an application and/or data which may be used when computer processes are performed on a server away from the computing device 1510. The resource 1524 may further include a service provided through the Internet and/or a subscriber network such as a cellular or Wireless Fidelity (Wi-Fi) network.

The platform 1522 may abstract the resource and functions to connect the computing device 1510 to other computing devices. The platform 1522 may also be configured to abstract a hierarchy of the resource, to provide a hierarchy of a corresponding level of requirement encountered for the resource 1524 implemented through the platform 1522. Therefore, in an interconnected device embodiment, implementations of the functions described here may be distributed throughout the system 1500. For example, the functions may be partially implemented on the computing device 1510 and through the platform 1522 abstracting functions of the cloud 1520.

An embodiment of the disclosure further provides a computer program product, and the computer program product includes computer-executable instructions. The computer-executable instructions implement any one of the above method for processing geometry stream data when the computer-executable instructions are executed by a processor.

It should be understood that for the sake of clarity, the embodiments of the disclosure are described with reference to different functional units. However, it will be apparent that function of each functional unit may be implemented in a single unit, in multiple units or as a part of other functional units without departing from the disclosure. For example, functionality described as being performed by a single unit may be performed by multiple different units. Therefore, reference to a specific functional unit is only considered as reference to an appropriate unit providing the described functionality, rather than indicating a strict logical or physical structure or organization. Therefore, the disclosure may be implemented in a single unit, or may be physically and functionally distributed between different units and circuits.

Although the disclosure has been described with reference to some embodiments, it is not intended for the disclosure to be limited to specific forms set forth here. Instead, the scope of the disclosure is limited only by the appended claims. Additionally, although individual features may be included in different claims, these features may be advantageously combined possibly, and inclusion of these features in different claims does not imply that combinations of these features are not feasible and/or advantageous. An order of features in the claims does not imply that these features must be in any specific order in which these features operate. Furthermore, in the claims, a word "including" does not exclude other elements, and a term "a" or "an" does not exclude "multiple". Reference numerals in the claims are provided only as clear examples, and should not be explained as limiting the scope of the claims in any manner.

### Industrial Applicability

The embodiments of the disclosure disclose a method and apparatus for processing geometry stream data, a computing device, a storage medium, and a computer program product. The method is performed by a target geometry pipeline allocation module, and includes the following operations. A data processing request is acquired. Here, the data processing request indicates a topology of a to-be-processed geometry stream data and whether the to-be-processed geometry stream data includes shearing point data. In response to the to-be-processed geometry stream data not including the shearing point data, target data to be split in a current batch is acquired from the to-be-processed geometry stream data. The target data is split into data of corresponding primitive geometries according to the topology. The method for processing geometry stream data of the disclosure is intended to efficiently process the geometry stream data, and may improve processing efficiency in case that multiple geometry pipelines are provided to process the geometry stream data. to (2*q-4+2n+8)-th point data are split into triangle data with adjacency information.

In some embodiments, the start point data, the end point data and splitting manner are performed according to the following operations.
(1) The operation of determining, from multiple point data of the to-be-processed geometry stream data, the start point data of the target data to be split in the current batch according to the ordinal number and the topology of the to-be-processed geometry stream data includes the following operations. In response to the topology of the to-be-processed geometry stream data being a control package list with k points, a (k*q-k+1)-th point data from multiple point data of the to-be-processed geometry stream data is taken as the start point data, here k is a positive integer. Since the data of primitive geometries obtained by splitting the geometry stream data having a control package list topology with k points is data of primitive geometries including k points, the data of primitive geometries is geometry point data when k=1, the data of primitive geometries is line data when k=2, the data of primitive geometries is triangle data when k=3, and the data of primitive geometries is customized data of primitive geometries when k>3, and k point data are required to constitute one data of primitive geometries including k points, and no common point data is present between two adjacent data of primitive geometries including k points in the control package list topology with k points, then it may be determined, according to these characteristics of the control package list topology with k points, that the start point data of the target data to be split in the current batch is the (k*q-k+1)-th point data from the geometry stream data.
(2) The operation of determining, from multiple point data of the to-be-processed geometry stream data, the end point data of the target data to be split in the current batch according to the start point data, the number of primitive geometries to be processed by each of the geometry pipelines per batch, and the topology of the to-be-processed geometry stream data includes the following operations. A (k*q+k*n-n)-th point data from multiple point data of the to-be-processed geometry stream data is taken as the end point data. Since k point data are required to constitute one data of primitive geometries including k points, and no common point data is present between two adjacent data of primitive geometries including k points in the control package list topology with k points, then in case that the target geometry pipeline processor needs to process n data of primitive geometries including k points per batch, the position of the end point data is increased by (k*n-n+k-1) based on the position of the start point data.

According to a splitting rule of the control package list topology with k points, the (k*q-k+1)-th to (k*q+k*n-n)-th point data are split into data of primitive geometries including k points.

The above embodiments provide exemplary implementations for various geometry stream data in the field of graphics processing respectively, of which all may significantly improve processing efficiency and achieve decentralization of geometry pipelines.

FIG. 14 is an exemplary structural block diagram of an apparatus for processing geometry stream data 1400 provided in an embodiment of the disclosure. The apparatus for processing geometry stream data is one of multiple apparatuses for processing geometry stream data included in a system for processing geometry stream data, the system for processing geometry stream data includes multiple geometry pipelines of which each includes an apparatus for processing geometry stream data and a geometry pipeline processor. The apparatus for processing geometry stream data 1400 includes a request acquisition module 1401, a data acquisition module 1402, and a splitting module 1403. The request acquisition module 1401 is configured to acquire a data processing request, here the data processing request indicates a topology of a to-be-processed geometry stream data and whether the to-be-processed geometry stream data includes shearing point data, and the shearing point data indicates that no common vertex is present between a topology where a previous point data of the shearing point data is located and a topology where a next point data of the shearing point data is located. The data acquisition module 1402 is configured to acquire, from the to-be-processed geometry stream data, target data to be split in a current batch in response to the to-be-processed geometry stream data not including the shearing point data, here the target data is at least a part of the to-be-processed geometry stream data. The splitting module 1403 is configured to split, according to the topology of the to-be-processed geometry stream data, the target data into data of corresponding primitive geometries to be processed by a geometry pipeline processor in a target geometry pipeline, here the target pipeline is a geometry pipeline to which the target pipeline allocation module belongs.

It should be noted that the above various modules may be implemented in software or hardware or a combination of software and hardware. Multiple different modules may be implemented in the same software or hardware structure, or one module may be implemented by multiple different software or hardware structures.

In the apparatus for processing geometry stream data according to some embodiments of the disclosure, in case that no shearing point is present in the to-be-processed geometry stream data, the geometry pipeline allocation module of each of the geometry pipelines only needs to acquire the target data from the to-be-processed geometry stream data, and split the target data to obtain the data of primitive geometries (data of primitive geometries to be processed by the geometry pipeline in the current batch), instead of having to acquire all the to-be-processed geometry stream data. Therefore, throughput of the geometry pipeline allocation module of each of the geometry pipelines upon acquiring data each time is significantly reduced, and splitting efficiency of the geometry pipeline is greatly improved.

FIG. 15 illustrates an exemplary system 1500, the system 1500 includes an exemplary computing device 1510 representing one or more systems and/or devices which may implement various methods described here. For example, the computing device 1510 may be a server of a service provider, a device associated with a server, a system on chip (SoC), and/or any other suitable computing devices or systems. The apparatus for processing geometry stream data 1400 as described above with reference to FIG. 14 may take a form of the computing device 1510. Alternatively, the apparatus for processing geometry stream data 1400 may be implemented as a computer program in form of an application 1516.

The exemplary computing device 1510 as shown in the figure includes a processing system 1511, one or more computer-readable media 1512, and one or more input/output (I/O) interfaces 1513 which are communicatively coupled to each other. Although not shown, the computing device 1510 may further include a system bus or other data and command transmission systems which couple various components to each other. The system bus may include any one or combination of different bus structures such as a memory bus or memory controller, a peripheral bus, a universal serial bus (USB), and/or a processor or local bus utilizing any one of various bus architectures. Various other examples such as control and data lines are also contemplated.

The processing system 1511 represents a function of performing one or more operations by using hardware. Therefore, the processing system 1511 is illustrated as including a hardware element 1514 which may be configured as a processor, a functional block, etc. This may include other logic devices implemented as Application Specific Integrated Circuits (ASICs) in hardware or formed by using one or more semiconductors. The hardware element 1514 is not limited by a material from which it is formed or a processing mechanism used therein. For example, the processor may be composed of (multiple) semiconductors and/or transistors (such as electronic ICs). In such context, processor-executable instructions may be electronic executable instructions.

The computer-readable medium 1512 is illustrated as including a memory/storage device 1515. The memory/storage device 1515 represents a memory/storage capacity associated with one or more computer-readable media. The memory/storage device 1515 may include a volatile medium (such as a Random Access Memory (RAM)) and/or a non-volatile medium (such as a Read-Only Memory (ROM), a flash memory, an optical disk, a magnetic disk, etc.). The memory/storage device 1515 may include a fixed medium (such as RAM, ROM, a fixed Hard Disk Drive (HDD), etc.) and a mobile medium (such as a flash memory, a mobile HDD, an optical disk, etc.). The computer-readable medium 1512 may be configured in various other manners as described below.

One or more I/O interfaces 1513 represent a function which allows a user to input commands and information to the computing device 1510 by using various input devices, and optionally also allows information to be presented to the user and/or other components or devices by using various output devices. Examples of the input devices include a keyboard, a cursor control device (such as a mouse), a microphone (such as, used for inputting voice), a scanner, a touch function (such as a capacitive or other sensors configured to detect physical touches), a camera (for example, it may use a visible or invisible wavelength (such as an infrared frequency) to detect motions which do not involve touches as gestures), etc. Examples of the output devices include a display device, a speaker, a printer, a network card, a tactile response device, etc. Therefore, the computing device 1510 may be configured in various manners as described below, to support user interaction.

The computing device 1510 further includes an application 1516. For example, the application 1516 may be a software instance of the apparatus for processing geometry stream data 1400, and implement technologies described here in combination with other elements in the computing device 1510.

In the disclosure, various technologies may be described in a general context of software and hardware elements or program modules. In general, these modules include routines, programs, objects, elements, components, data structures, or the like which perform a specific task or implement a specific abstract data type. Terms "module", "function" and "component" as used here generally represent software, firmware, hardware or a combination thereof. Characteristics of the technologies described here are independent of platforms, which means that these technologies may be implemented on various computing platforms provided with various processors.

Implementations of the described modules and technologies may be stored on or transmitted across a certain form of computer-readable medium. The computer-readable medium may include various media which may be accessed by the computing device 1510. As an example rather than limitation, the computer-readable medium may include a "computer-readable storage medium" and a "computer-readable signal medium".

In contrast to simple signal transmission, carrier wave or signal itself, the "computer-readable storage medium" refers to a medium and/or device capable of persistently storing information, and/or a tangible storage device. Therefore, the computer-readable storage medium refers to a non-signal carrying medium. The computer-readable storage medium include hardware such as a volatile medium and a non-volatile medium, a mobile medium and a non-mobile medium, and/or a storage device implemented in a method or technology suitable for storing information (such as computer-readable instructions, data structures, program modules, logic elements/circuits, or other data). Examples of the computer-readable storage medium may include, but are not limited to RAM, ROM, an Electrically Erasable Programmable Read-Only Memory (EEPROM), a flash memory or other memory technologies, a Compact Disc Read-Only Memory (CD-ROM), a Digital Versatile Disc (DVD) or other optical storage devices, a hard disk, a cassette, a magnetic tape, a magnetic disk storage device or other magnetic storage devices, or other storage devices, a tangible medium or product suitable for storing desired information and accessible by a computer.

The "computer-readable signal medium" refers to a signal carrying medium which is configured to send instructions to hardware of the computing device 1510, for example through a network. Typically, the signal medium may embody computer-readable instructions, data structures, program modules or other data in a modulated data signal such as a carrier wave, a data signal or other transmission mechanisms. The signal medium further includes any information transfer medium. The term "modulated data signal" refers to a signal of which one or more of characteristics are set or changed to encode information into the signal. As an example rather than limitation, a communication medium includes a wired medium such as a wired network or direct connection, and a wireless medium such as an acoustic medium, a Radio Frequency (RF) medium, an infrared medium and other wireless media.

As described previously, the hardware element 1514 and the computer-readable medium 1512 represent instructions, modules, programmable device logics and/or fixed device logics implemented in form of hardware, which may implement at least some aspects of the technologies described here in some embodiments. The hardware element may include IC or SoC, ASIC, a Field Programmable Gate Array (FPGA), a Complex Programmable Logic Device (CPLD), and other implementations in silicon or components of other hardware devices. In such context, the hardware element may be used as a processing device which performs program tasks defined by instructions, modules and/or logics embodied by the hardware element, and a hardware device configured to store instructions for execution, such as the computer-readable storage medium as described previously.

A combination of the foregoing items may also be used to implement various technologies and modules here. Therefore, the software, hardware or program module and other program modules may be implemented as one or more instructions and/or logics embodied on a certain form of computer-readable storage medium and/or by one or more hardware elements 1514. The computing device 1510 may be configured to implement a specific instruction and/or function corresponding to the software and/or hardware module. Therefore, for example, with usage of the computer-readable storage medium and/or the hardware element 1514 of the processing system, a module may be at least partially implemented in hardware as a module which may be performed by the computing device 1510 as software. The instruction and/or function may be performed/operated by one or more products (such as one or more computing devices 1510 and/or processing systems 1011) to implement the technologies, modules and examples described here.

In various implementations, the computing device 1510 may use various different configurations. For example, the computing device 1510 may be implemented as a computer-type device including a personal computer, a desktop computer, a multi-screen computer, a laptop computer, a netbook, etc. The computing device 1510 may also be implemented as a mobile device-type device including a mobile device such as a mobile phone, a portable music player, a portable game device, a tablet computer, a multi-screen computers, etc. The computing device 1510 may also be implemented as a TV-type device including a device provided with a usually large screen or connected to a usually large screen in a casual viewing environment. These devices include TV, a set-top box, a game console, etc.

The technologies described here may be supported by these various configurations of the computing device 1510, and are not limited to specific examples of the technologies described here. Functions may also be entirely or partially implemented on a "cloud" 1520 by using a distributed system, for example, through a platform 1522 as described below.

The cloud 1520 includes and/or represents the platform 1522 for a resource 1524. The platform 1522 abstracts underlying functions of hardware (such as a server) and software resources of the cloud 1520. The resource 1524 may include an application and/or data which may be used when computer processes are performed on a server away from the computing device 1510. The resource 1524 may further include a service provided through the Internet and/or a subscriber network such as a cellular or Wireless Fidelity (Wi-Fi) network.

The platform 1522 may abstract the resource and functions to connect the computing device 1510 to other computing devices. The platform 1522 may also be configured to abstract a hierarchy of the resource, to provide a hierarchy of a corresponding level of requirement encountered for the resource 1524 implemented through the platform 1522. Therefore, in an interconnected device embodiment, implementations of the functions described here may be distributed throughout the system 1500. For example, the functions may be partially implemented on the computing device 1510 and through the platform 1522 abstracting functions of the cloud 1520.

An embodiment of the disclosure further provides a computer program product, and the computer program product includes computer-executable instructions. The computer-executable instructions implement any one of the above method for processing geometry stream data when the computer-executable instructions are executed by a processor.

It should be understood that for the sake of clarity, the embodiments of the disclosure are described with reference to different functional units. However, it will be apparent that function of each functional unit may be implemented in a single unit, in multiple units or as a part of other functional units without departing from the disclosure. For example, functionality described as being performed by a single unit may be performed by multiple different units. Therefore, reference to a specific functional unit is only considered as reference to an appropriate unit providing the described functionality, rather than indicating a strict logical or physical structure or organization. Therefore, the disclosure may be implemented in a single unit, or may be physically and functionally distributed between different units and circuits.

Although the disclosure has been described with reference to some embodiments, it is not intended for the disclosure to be limited to specific forms set forth here. Instead, the scope of the disclosure is limited only by the appended claims. Additionally, although individual features may be included in different claims, these features may be advantageously combined possibly, and inclusion of these features in different claims does not imply that combinations of these features are not feasible and/or advantageous. An order of features in the claims does not imply that these features must be in any specific order in which these features operate. Furthermore, in the claims, a word "including" does not exclude other elements, and a term "a" or "an" does not exclude "multiple". Reference numerals in the claims are provided only as clear examples, and should not be explained as limiting the scope of the claims in any manner.

### Industrial Applicability

The embodiments of the disclosure disclose a method and apparatus for processing geometry stream data, a computing device, a storage medium, and a computer program product. The method is performed by a target geometry pipeline allocation module, and includes the following operations. A data processing request is acquired. Here, the data processing request indicates a topology of a to-be-processed geometry stream data and whether the to-be-processed geometry stream data includes shearing point data. In response to the to-be-processed geometry stream data not including the shearing point data, target data to be split in a current batch is acquired from the to-be-processed geometry stream data. The target data is split into data of corresponding primitive geometries according to the topology. The method for processing geometry stream data of the disclosure is intended to efficiently process the geometry stream data, and may improve processing efficiency in case that multiple geometry pipelines are provided to process the geometry stream data.

## Claims

1. A method (200) for processing geometry stream data, performed by a target geometry pipeline allocation module, the target geometry pipeline allocation module being one of a plurality of geometry pipeline allocation modules comprised in a system for processing geometry stream data, the system for processing geometry stream data comprising a plurality of geometry pipelines of which each comprises a geometry pipeline allocation module and a geometry pipeline processor, the method for processing geometry stream data comprising:
acquiring (S201) a data processing request, wherein the data processing request indicates a topology of a to-be-processed geometry stream data and whether the to-be-processed geometry stream data comprises shearing point data, and wherein the shearing point data indicates that no common vertex is present between a topology where a previous point data of the shearing point data is located and a topology where a next point data of the shearing point data is located;
the method (200) further comprises:
in response to the to-be-processed geometry stream data not comprising the shearing point data (S202), perform:
acquiring (S203), from the to-be-processed geometry stream data, target data to be split in a current batch rather than acquiring all the to-be-processed geometry stream data, wherein the target data is at least a part of the to-be-processed geometry stream data; and
splitting (S204), according to the topology of the to-be-processed geometry stream data, the target data into data of corresponding primitive geometries to be processed by a geometry pipeline processor in a target geometry pipeline, wherein the target pipeline is a geometry pipeline to which the target geometry pipeline allocation module belongs;
in response to the to-be-processed geometry stream data comprising the shearing point data (S301), perform:
acquiring (S301) the to-be-processed geometry stream data;
splitting (S302), according to the topology of the to-be-processed geometry stream data, the to-be-processed geometry stream data into data of a plurality of primitive geometries; and
determining (S303), from the data of the plurality of primitive geometries, data of primitive geometries to be processed by the target geometry pipeline in the current batch, to be processed by the geometry pipeline processor in the target geometry pipeline.

2. The method (200) for processing geometry stream data of claim 1, wherein acquiring, from the to-be-processed geometry stream data, the target data to be split in the current batch comprises:
determining a sequence number of the target geometry pipeline to which the target geometry pipeline allocation module belongs, a number of the plurality of geometry pipelines, and a number of primitive geometries to be processed by each of the geometry pipelines per batch; and
acquiring, from the to-be-processed geometry stream data, the target data to be split in the current batch according to the sequence number of the target geometry pipeline to which the target geometry pipeline allocation module belongs, the number of the plurality of geometry pipelines, the number of primitive geometries to be processed by each of the geometry pipelines per batch, and the topology of the to-be-processed geometry stream data.

3. The method (200) for processing geometry stream data of claim 2, wherein acquiring, from the to-be-processed geometry stream data, the target data to be split in the current batch according to the sequence number of the target geometry pipeline to which the target geometry pipeline allocation module belongs, the number of the plurality of geometry pipelines, the number of primitive geometries to be processed by each of the geometry pipelines per batch, and the topology of the to-be-processed geometry stream data comprises:
determining (S401), from a plurality of point data of the to-be-processed geometry stream data, a start point data of the target data to be split in the current batch according to the sequence number of the target geometry pipeline to which the target geometry pipeline allocation module belongs, the number of the plurality of geometry pipelines, the number of primitive geometries to be processed by each of the geometry pipelines per batch, and the topology of the to-be-processed geometry stream data;
determining (S402), from the plurality of point data of the to-be-processed geometry stream data, an end point data of the target data to be split in the current batch according to the start point data, the number of primitive geometries to be processed by each of the geometry pipelines per batch, and the topology of the to-be-processed geometry stream data; and
taking (S403) point data between the start point data and the end point data from the plurality of point data of the to-be-processed geometry stream data as the target data to be split in the current batch.

4. The method (200) for processing geometry stream data of claim 3, wherein determining, from the plurality of point data of the to-be-processed geometry stream data, the start point data of the target data to be split in the current batch according to the sequence number of the target geometry pipeline to which the target geometry pipeline allocation module belongs, the number of the plurality of geometry pipelines, the number of primitive geometries to be processed by each of the geometry pipelines per batch, and the topology of the to-be-processed geometry stream data comprises:
determining an ordinal number of a first primitive geometry in all primitive geometries of the to-be-processed geometry stream data, according to the number of the plurality of geometry pipelines, the sequence number of the target geometry pipeline to which the target geometry pipeline allocation module belongs, and the number of primitive geometries to be processed by each of the geometry pipelines per batch, wherein the first primitive geometry is a first primitive geometry from primitive geometries to be processed by the target geometry pipeline in the current batch; and
determining, from the plurality of point data of the to-be-processed geometry stream data, the start point data of the target data to be split in the current batch according to the ordinal number and the topology of the to-be-processed geometry stream data.

5. The method (200) for processing geometry stream data of claim 4, wherein determining the ordinal number of the first primitive geometry in all primitive geometries of the to-be-processed geometry stream data, according to the number of the plurality of geometry pipelines, the sequence number of the target geometry pipeline to which the target geometry pipeline allocation module belongs, and the number of primitive geometries to be processed by each of the geometry pipelines per batch comprises:
determining the ordinal number according to a following formula:$q = \left(a-1\right) ∗ n + 1 + n ∗ m ∗ b ,$
wherein q is the ordinal number, m is the number of the plurality of geometry pipelines and m is a positive integer greater than 1, a is the sequence number of the target geometry pipeline to which the target geometry pipeline allocation module belongs and a is greater than 0 and less than or equal to m, n is the number of primitive geometries to be processed by each of the geometry pipelines per batch and n is a positive integer, b is a number of batches which have been processed by the target geometry pipeline allocation module and b is a non-negative number.

6. The method (200) for processing geometry stream data of claim 5, wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a point list, taking a q-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
taking a (q+n-1)-th point data from the plurality of point data of the to-be-processed geometry stream data as the end point data.

7. The method (200) for processing geometry stream data of claim 5, wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a line list, taking a (2*q-1)-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
taking a (2*q+2*n-2)-th point data from the plurality of point data of the to-be-processed geometry stream data as the end point data,
or wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a line list with adjacency information, taking a (4*q-3)-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
taking a (4*q+4*n-4)-th point data from the plurality of point data of the to-be-processed geometry stream data as the end point data.

8. The method (200) for processing geometry stream data of claim 5, wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a line strip, taking a q-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
taking a (q+n+1)-th point data from the plurality of point data of the to-be-processed geometry stream data as the end point data,
or wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a line strip with adjacency information, taking a q-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
taking a (q+n+3)-th point data from the plurality of point data of the to-be-processed geometry stream data as the end point data.

9. The method (200) for processing geometry stream data of claim 5, wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a line loop, taking a q-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
in response to not requiring the geometry pipeline processor of the target geometry pipeline to process a last line data from all line data of the to-be-processed geometry stream data, taking a (q+n+1)-th point data from the plurality of point data of the to-be-processed geometry stream data as the end point data; and
in response to requiring the geometry pipeline processor of the target geometry pipeline to process the last line data from all line data of the to-be-processed geometry stream data, taking a first point data from the plurality of point data of the to-be-processed geometry stream data as the end point data.

10. The method (200) for processing geometry stream data of claim 5, wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a triangle list, taking a (3*q-2)-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
taking a (3*q+3*n-3)-th point data from the plurality of point data of the to-be-processed geometry stream data as the end point data,
or wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a triangle list with adjacency information, taking a (6*q-5)-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
taking a (6*q+6*n-6)-th point data from the plurality of point data of the to-be-processed geometry stream data as the end point data.

11. The method (200) for processing geometry stream data of claim 5, wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a triangle strip, taking a q-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
taking a (q+n+1)-th point data from the plurality of point data of the to-be-processed geometry stream data as the end point data,
or wherein determining, from the plurality of point data of the to-be-processed geometry stream data, the start point data of the target data to be split in the current batch according to the ordinal number and the topology of the to-be-processed geometry stream data comprises:
in response to the topology being a triangle strip with adjacency information and q being equal to 1, taking a first point data from the plurality of point data of the to-be-processed geometry stream data as the start point data; and
in response to the topology of the to-be-processed geometry stream data being the triangle strip with adjacency information and q being greater than 1, taking a (2*q-4)-th point data from the plurality of point data of the to-be-processed geometry stream data as the start point data,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
in response to q being equal to 1, taking a (2*n+7)-th point data from the plurality of point data of the to-be-processed geometry stream data as the end point data; and
in response to q being greater than 1, taking a (2*q-4+2n+8)-th point data from the plurality of point data of the to-be-processed geometry stream data as the end point data.

12. The method (200) for processing geometry stream data of claim 5, wherein determining, from the plurality of point data of the to-be-processed geometry stream data, the start point data of the target data to be split in the current batch according to the ordinal number and the topology of the to-be-processed geometry stream data comprises:
in response to the topology of the to-be-processed geometry stream data being a control package list with k points, taking a (k*q-k+1)-th point data from the plurality of point data of the to-be-processed geometry stream data as the start point data, wherein k is a positive integer,
determining, from the plurality of point data of the to-be-processed geometry stream data, the end point data of the target data to be split in the current batch according to the start point data, the number of primitive geometries to be processed by each of the geometry pipelines per batch, and the topology of the to-be-processed geometry stream data comprises:
taking a (k*q+k*n-n)-th point data from the plurality of point data of the to-be-processed geometry stream data as the end point data.

13. A computing device, comprising a memory and a processor, wherein the memory stores computer-executable instructions that when executed by the processor, enable the processor to perform the method of any one of claims 1 to 12.

14. A computer-readable storage medium having stored thereon computer-executable instructions that when executed, implement the method of any one of claims 1 to 12.

## Patentansprüche

1. Ein Verfahren (200) zum Verarbeiten von Geometriestromdaten, das von einem Zielgeometriepipeline-Zuweisungsmodul durchgeführt wird, wobei das Zielgeometriepipeline-Zuweisungsmodul eines von mehreren Geometriepipeline-Zuweisungsmodulen ist, die in einem System zum Verarbeiten von Geometriestromdaten enthalten sind, wobei das System zum Verarbeiten von Geometriestromdaten mehrere Geometriepipelines umfasst, von denen jede ein Geometriepipeline-Zuweisungsmodul und einen Geometriepipelineprozessor umfasst, wobei das Verfahren zum Verarbeiten von Geometriestromdaten Folgendes umfasst:
Erfassen (S201) einer Datenverarbeitungsanforderung, wobei die Datenverarbeitungsanforderung eine Topologie von zu verarbeitenden Geometriestromdaten angibt und angibt, ob die zu verarbeitenden Geometriestromdaten Scherpunktdaten umfassen, und wobei die Scherpunktdaten angeben, dass zwischen einer Topologie, in der sich vorherige Punktdaten der Scherpunktdaten befinden, und einer Topologie, in der sich nächste Punktdaten der Scherpunktdaten befinden, kein gemeinsamer Scheitelpunkt vorhanden ist; das Verfahren (200) umfasst ferner Folgendes:
als Reaktion darauf, dass die zu verarbeitenden Geometriestromdaten die Scherpunktdaten nicht umfassen (S202), Durchführen von:
Erfassen (S203) von aufzuteilenden Zieldaten in einem aktuellen Batch aus den zu verarbeitenden Geometriestromdaten, anstatt alle zu verarbeitenden Geometriestromdaten zu erfassen, wobei die Zieldaten zumindest ein Teil der zu verarbeitenden Geometriestromdaten sind; und
Aufteilen (S204) der Zieldaten gemäß der Topologie der zu verarbeitenden Geometriestromdaten in Daten entsprechender primitiver Geometrien, die von einem Geometriepipelineprozessor in einer Zielgeometriepipeline zu verarbeiten sind, wobei die Zielpipeline eine Geometriepipeline ist, zu der das Zielgeometriepipeline-Zuweisungsmodul gehört;
als Reaktion darauf, dass die zu verarbeitenden Geometriestromdaten die Scherpunktdaten umfassen (S301), Durchführen von:
Erfassen (S301) der zu verarbeitenden Geometriestromdaten;
Aufteilen (S302) der zu verarbeitenden Geometriestromdaten gemäß der Topologie der zu verarbeitenden Geometriestromdaten in Daten mehrerer primitiver Geometrien; und Bestimmen (S303), aus den Daten der mehreren primitiven Geometrien, von Daten primitiver Geometrien, die von der Zielgeometriepipeline im aktuellen Batch zu verarbeiten sind, zur Verarbeitung durch den Geometriepipelineprozessor in der Zielgeometriepipeline.

2. Das Verfahren (200) zum Verarbeiten von Geometriestromdaten nach Patentanspruch 1, wobei das Erfassen der im aktuellen Batch aufzuteilenden Zieldaten aus den zu verarbeitenden Geometriestromdaten Folgendes umfasst:
Bestimmen einer Sequenznummer der Zielgeometriepipeline, zu der das Zielgeometriepipeline-Zuweisungsmodul gehört, einer Anzahl der mehreren Geometriepipelines und einer Anzahl primitiver Geometrien, die von jeder der Geometriepipelines pro Batch zu verarbeiten sind; und
Erfassen der im aktuellen Batch aufzuteilenden Zieldaten aus den zu verarbeitenden Geometriestromdaten gemäß der Sequenznummer der Zielgeometriepipeline, zu der das Zielgeometriepipeline-Zuweisungsmodul gehört, der Anzahl der mehreren Geometriepipelines, der Anzahl primitiver Geometrien, die von jeder der Geometriepipelines pro Batch zu verarbeiten sind, und der Topologie der zu verarbeitenden Geometriestromdaten.

3. Das Verfahren (200) zum Verarbeiten von Geometriestromdaten nach Patentanspruch 2, wobei das Erfassen der im aktuellen Batch aufzuteilenden Zieldaten aus den zu verarbeitenden Geometriestromdaten gemäß der Sequenznummer der Zielgeometriepipeline, zu der das Zielgeometriepipeline-Zuweisungsmodul gehört, der Anzahl der mehreren Geometriepipelines, der Anzahl primitiver Geometrien, die von jeder der Geometriepipelines pro Batch zu verarbeiten sind, und der Topologie der zu verarbeitenden Geometriestromdaten Folgendes umfasst:
Bestimmen (S401) von Startpunktdaten der im aktuellen Batch aufzuteilenden Zieldaten aus mehreren Punktdaten der zu verarbeitenden Geometriestromdaten gemäß der Sequenznummer der Zielgeometriepipeline, zu der das Zielgeometriepipeline-Zuweisungsmodul gehört, der Anzahl der mehreren Geometriepipelines, der Anzahl primitiver Geometrien, die von jeder der Geometriepipelines pro Batch zu verarbeiten sind, und der Topologie der zu verarbeitenden Geometriestromdaten;
Bestimmen (S402) von Endpunktdaten der im aktuellen Batch aufzuteilenden Zieldaten aus den mehreren Punktdaten der zu verarbeitenden Geometriestromdaten gemäß den Startpunktdaten, der Anzahl primitiver Geometrien, die von jeder der Geometriepipelines pro Batch zu verarbeiten sind, und der Topologie der zu verarbeitenden Geometriestromdaten; und Heranziehen (S403) von Punktdaten zwischen den Startpunktdaten und den Endpunktdaten aus den mehreren Punktdaten der zu verarbeitenden Geometriestromdaten als die im aktuellen Batch aufzuteilenden Zieldaten.

4. Das Verfahren (200) zum Verarbeiten von Geometriestromdaten nach Patentanspruch 3, wobei das Bestimmen der Startpunktdaten der im aktuellen Batch aufzuteilenden Zieldaten aus den mehreren Punktdaten der zu verarbeitenden Geometriestromdaten gemäß der Sequenznummer der Zielgeometriepipeline, zu der das Zielgeometriepipeline-Zuweisungsmodul gehört, der Anzahl der mehreren Geometriepipelines, der Anzahl primitiver Geometrien, die von jeder der Geometriepipelines pro Batch zu verarbeiten sind, und der Topologie der zu verarbeitenden Geometriestromdaten Folgendes umfasst:
Bestimmen einer Ordnungszahl einer ersten primitiven Geometrie unter allen primitiven Geometrien der zu verarbeitenden Geometriestromdaten gemäß der Anzahl der mehreren Geometriepipelines, der Sequenznummer der Zielgeometriepipeline, zu der das Zielgeometriepipeline-Zuweisungsmodul gehört, und der Anzahl primitiver Geometrien, die von jeder der Geometriepipelines pro Batch zu verarbeiten sind, wobei die erste primitive Geometrie eine erste primitive Geometrie aus primitiven Geometrien ist, die von der Zielgeometriepipeline im aktuellen Batch zu verarbeiten sind; und
Bestimmen der Startpunktdaten der im aktuellen Batch aufzuteilenden Zieldaten aus den mehreren Punktdaten der zu verarbeitenden Geometriestromdaten gemäß der Ordnungszahl und der Topologie der zu verarbeitenden Geometriestromdaten.

5. Das Verfahren (200) zum Verarbeiten von Geometriestromdaten nach Patentanspruch 4, wobei das Bestimmen der Ordnungszahl der ersten primitiven Geometrie unter allen primitiven Geometrien der zu verarbeitenden Geometriestromdaten gemäß der Anzahl der mehreren Geometriepipelines, der Sequenznummer der Zielgeometriepipeline, zu der das Zielgeometriepipeline-Zuweisungsmodul gehört, und der Anzahl primitiver Geometrien, die von jeder der Geometriepipelines pro Batch zu verarbeiten sind, Folgendes umfasst:
Bestimmen der Ordnungszahl gemäß einer folgenden Formel:$q = \left(a-1\right) * n + 1 + n * m * b$
wobei q die Ordnungszahl ist, m die Anzahl der mehreren Geometriepipelines ist und m eine positive ganze Zahl größer als 1 ist, a die Sequenznummer der Zielgeometriepipeline ist, zu der das Zielgeometriepipeline-Zuweisungsmodul gehört, und a größer als 0 und kleiner als oder gleich m ist, n die Anzahl primitiver Geometrien ist, die von jeder der Geometriepipelines pro Batch zu verarbeiten sind, und n eine positive ganze Zahl ist, b eine Anzahl von Batches ist, die von dem Zielgeometriepipeline-Zuweisungsmodul verarbeitet worden sind, und b eine nichtnegative Zahl ist.

6. Das Verfahren (200) zum Verarbeiten von Geometriestromdaten nach Patentanspruch 5, wobei das Bestimmen der Startpunktdaten der im aktuellen Batch aufzuteilenden Zieldaten aus den mehreren Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie der zu verarbeitenden Geometriestromdaten eine Punktliste ist, Heranziehen der q-ten Punktdaten aus den mehreren Punktdaten der zu verarbeitenden Geometriestromdaten als die Startpunktdaten,
das Bestimmen der Endpunktdaten der im aktuellen Batch aufzuteilenden Zieldaten aus den mehreren Punktdaten der zu verarbeitenden Geometriestromdaten gemäß den Startpunktdaten, der Anzahl primitiver Geometrien, die von jeder der Geometriepipelines pro Batch zu verarbeiten sind, und der Topologie der zu verarbeitenden Geometriestromdaten Folgendes umfasst:
Heranziehen der (q+n-1)-ten Punktdaten aus den mehreren Punktdaten der zu verarbeitenden Geometriestromdaten als die Endpunktdaten.

7. Das Verfahren (200) zum Verarbeiten von Geometriestromdaten nach Patentanspruch 5, wobei das Bestimmen der Startpunktdaten der im aktuellen Batch aufzuteilenden Zieldaten aus den mehreren Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie der zu verarbeitenden Geometriestromdaten eine Linienliste ist, Heranziehen der (2*q-1)-ten Punktdaten aus den mehreren Punktdaten der zu verarbeitenden Geometriestromdaten als die Startpunktdaten,
das Bestimmen der Endpunktdaten der im aktuellen Batch aufzuteilenden Zieldaten aus den mehreren Punktdaten der zu verarbeitenden Geometriestromdaten gemäß den Startpunktdaten, der Anzahl primitiver Geometrien, die von jeder der Geometriepipelines pro Batch zu verarbeiten sind, und der Topologie der zu verarbeitenden Geometriestromdaten Folgendes umfasst:
Heranziehen der (2*q+2*n-2)-ten Punktdaten aus den mehreren Punktdaten der zu verarbeitenden Geometriestromdaten als die Endpunktdaten,
oder wobei das Bestimmen der Startpunktdaten der im aktuellen Batch aufzuteilenden Zieldaten aus den mehreren Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie der zu verarbeitenden Geometriestromdaten eine Linienliste mit Adjazenzinformationen ist, Heranziehen der (4*q-3)-ten Punktdaten aus den mehreren Punktdaten der zu verarbeitenden Geometriestromdaten als die Startpunktdaten,
das Bestimmen der Endpunktdaten der aufzuteilenden Zieldaten im aktuellen Batch aus der Vielzahl von Punktdaten der zu verarbeitenden Geometriestromdaten gemäß den Startpunktdaten, der Anzahl der primitiven Geometrien, die von jeder der Geometriepipelines pro Batch zu verarbeiten sind, und der Topologie der zu verarbeitenden Geometriestromdaten Folgendes umfasst:
das Heranziehen der (4*q+4*n-4)-ten Punktdaten aus der Vielzahl von Punktdaten der zu verarbeitenden Geometriestromdaten als die Endpunktdaten.

8. Das Verfahren (200) zum Verarbeiten von Geometriestromdaten nach Patentanspruch 5, wobei das Bestimmen der Startpunktdaten der aufzuteilenden Zieldaten im aktuellen Batch aus der Vielzahl von Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie der zu verarbeitenden Geometriestromdaten ein Linienstreifen ist, das Heranziehen der q-ten Punktdaten aus der Vielzahl von Punktdaten der zu verarbeitenden Geometriestromdaten als die Startpunktdaten,
das Bestimmen der Endpunktdaten der aufzuteilenden Zieldaten im aktuellen Batch aus der Vielzahl von Punktdaten der zu verarbeitenden Geometriestromdaten gemäß den Startpunktdaten, der Anzahl der primitiven Geometrien, die von jeder der Geometriepipelines pro Batch zu verarbeiten sind, und der Topologie der zu verarbeitenden Geometriestromdaten Folgendes umfasst:
das Heranziehen der (q+n+1)-ten Punktdaten aus der Vielzahl von Punktdaten der zu verarbeitenden Geometriestromdaten als die Endpunktdaten,
oder wobei das Bestimmen der Startpunktdaten der aufzuteilenden Zieldaten im aktuellen Batch aus der Vielzahl von Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie der zu verarbeitenden Geometriestromdaten ein Linienstreifen mit Adjazenzinformationen ist, das Heranziehen der q-ten Punktdaten aus der Vielzahl von Punktdaten der zu verarbeitenden Geometriestromdaten als die Startpunktdaten,
das Bestimmen der Endpunktdaten der aufzuteilenden Zieldaten im aktuellen Batch aus der Vielzahl von Punktdaten der zu verarbeitenden Geometriestromdaten gemäß den Startpunktdaten, der Anzahl der primitiven Geometrien, die von jeder der Geometriepipelines pro Batch zu verarbeiten sind, und der Topologie der zu verarbeitenden Geometriestromdaten Folgendes umfasst:
das Heranziehen der (q+n+3)-ten Punktdaten aus der Vielzahl von Punktdaten der zu verarbeitenden
Geometriestromdaten als die Endpunktdaten.

9. Das Verfahren (200) zum Verarbeiten von Geometriestromdaten nach Patentanspruch 5, wobei das Bestimmen der Startpunktdaten der aufzuteilenden Zieldaten im aktuellen Batch aus der Vielzahl von Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie der zu verarbeitenden Geometriestromdaten eine Linienschleife ist, das Heranziehen der q-ten Punktdaten aus der Vielzahl von Punktdaten der zu verarbeitenden Geometriestromdaten als die Startpunktdaten,
das Bestimmen der Endpunktdaten der aufzuteilenden Zieldaten im aktuellen Batch aus der Vielzahl von Punktdaten der zu verarbeitenden Geometriestromdaten gemäß den Startpunktdaten, der Anzahl der primitiven Geometrien, die von jeder der Geometriepipelines pro Batch zu verarbeiten sind, und der Topologie der zu verarbeitenden Geometriestromdaten Folgendes umfasst:
als Reaktion darauf, dass es nicht erforderlich ist, dass der Geometriepipelineprozessor der Zielgeometriepipeline die letzten Liniendaten aus allen Liniendaten der zu verarbeitenden Geometriestromdaten verarbeitet, das Heranziehen der (q+n+1)-ten Punktdaten aus der Vielzahl von Punktdaten der zu verarbeitenden Geometriestromdaten als die Endpunktdaten; und
als Reaktion darauf, dass es erforderlich ist, dass der Geometriepipelineprozessor der Zielgeometriepipeline die letzten Liniendaten aus allen Liniendaten der zu verarbeitenden Geometriestromdaten verarbeitet, das Heranziehen der ersten Punktdaten aus der Vielzahl von Punktdaten der zu verarbeitenden Geometriestromdaten als die Endpunktdaten.

10. Das Verfahren (200) zum Verarbeiten von Geometriestromdaten nach Patentanspruch 5, wobei das Bestimmen,
aus der Vielzahl von Punktdaten der zu verarbeitenden Geometriestromdaten, der Startpunktdaten der aufzuteilenden Zieldaten im aktuellen Batch gemäß der Ordnungszahl und der Topologie der zu verarbeitenden Geometriestromdaten Folgendes umfasst:
als Reaktion darauf, dass die Topologie der zu verarbeitenden Geometriestromdaten eine Dreiecksliste ist, das Heranziehen der (3*q-2)-ten Punktdaten aus der Vielzahl von Punktdaten der zu verarbeitenden Geometriestromdaten als die Startpunktdaten,
das Bestimmen der Endpunktdaten der aufzuteilenden Zieldaten im aktuellen Batch aus der Vielzahl von Punktdaten der zu verarbeitenden Geometriestromdaten gemäß den Startpunktdaten, der Anzahl der primitiven Geometrien, die von jeder der Geometriepipelines pro Batch zu verarbeiten sind, und der Topologie der zu verarbeitenden Geometriestromdaten Folgendes umfasst:
das Heranziehen der (3*q+3*n-3)-ten Punktdaten aus der Vielzahl von Punktdaten der zu verarbeitenden Geometriestromdaten als die Endpunktdaten,
oder wobei das Bestimmen der Startpunktdaten der aufzuteilenden Zieldaten im aktuellen Batch aus der Vielzahl von Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie der zu verarbeitenden Geometriestromdaten eine Dreiecksliste mit Adjazenzinformationen ist, das Heranziehen der (6*q-5)-ten Punktdaten aus der Vielzahl von Punktdaten der zu verarbeitenden Geometriestromdaten als die Startpunktdaten,
das Bestimmen der Endpunktdaten der aufzuteilenden Zieldaten im aktuellen Batch aus der Vielzahl von Punktdaten der zu verarbeitenden Geometriestromdaten gemäß den Startpunktdaten, der Anzahl der primitiven Geometrien, die von jeder der Geometriepipelines pro Batch zu verarbeiten sind, und der Topologie der zu verarbeitenden Geometriestromdaten Folgendes umfasst:
das Heranziehen der (6*q+6*n-6)-ten Punktdaten aus der Vielzahl von Punktdaten der zu verarbeitenden Geometriestromdaten als die Endpunktdaten.

11. Das Verfahren (200) zum Verarbeiten von Geometriestromdaten nach Patentanspruch 5, wobei das Bestimmen der Startpunktdaten der aufzuteilenden Zieldaten im aktuellen Batch aus der Vielzahl von Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie der zu verarbeitenden Geometriestromdaten ein Dreiecksstreifen ist, das Heranziehen der q-ten Punktdaten aus der Vielzahl von Punktdaten der zu verarbeitenden Geometriestromdaten als die Startpunktdaten,
das Bestimmen der Endpunktdaten der aufzuteilenden Zieldaten im aktuellen Batch aus der Vielzahl von Punktdaten der zu verarbeitenden Geometriestromdaten gemäß den Startpunktdaten, der Anzahl der primitiven Geometrien, die von jeder der Geometriepipelines pro Batch zu verarbeiten sind, und der Topologie der zu verarbeitenden Geometriestromdaten Folgendes umfasst:
das Heranziehen der (q+n+1)-ten Punktdaten aus der Vielzahl von Punktdaten der zu verarbeitenden Geometriestromdaten als die Endpunktdaten,
oder wobei das Bestimmen der Startpunktdaten der aufzuteilenden Zieldaten im aktuellen Batch aus der Vielzahl von Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie ein Dreiecksstreifen mit Adjazenzinformationen ist und q gleich 1 ist, das Heranziehen der ersten Punktdaten aus der Vielzahl von Punktdaten der zu verarbeitenden Geometriestromdaten als die Startpunktdaten; und
als Reaktion darauf, dass die Topologie der zu verarbeitenden Geometriestromdaten der Dreiecksstreifen mit Adjazenzinformationen ist und q größer als 1 ist, das Heranziehen der (2*q-4)-ten Punktdaten aus den mehreren Punktdaten der zu verarbeitenden Geometriestromdaten als Startpunktdaten,
das Bestimmen der Endpunktdaten der aufzuteilenden Zieldaten im aktuellen Batch aus den mehreren Punktdaten der zu verarbeitenden Geometriestromdaten gemäß den Startpunktdaten, der Anzahl der von jeder der Geometriepipelines pro Batch zu verarbeitenden primitiven Geometrien und der Topologie der zu verarbeitenden Geometriestromdaten Folgendes umfasst:
als Reaktion darauf, dass q gleich 1 ist, das Heranziehen der (2*n+7)-ten Punktdaten aus den mehreren Punktdaten der zu verarbeitenden Geometriestromdaten als Endpunktdaten; und
als Reaktion darauf, dass q größer als 1 ist, das Heranziehen der (2*q-4+2n+8)-ten Punktdaten aus den mehreren Punktdaten der zu verarbeitenden Geometriestromdaten als Endpunktdaten.

12. Das Verfahren (200) zum Verarbeiten von Geometriestromdaten nach Patentanspruch 5, wobei das Bestimmen der Startpunktdaten der aufzuteilenden Zieldaten im aktuellen Batch aus den mehreren Punktdaten der zu verarbeitenden Geometriestromdaten gemäß der Ordnungszahl und der Topologie der zu verarbeitenden Geometriestromdaten Folgendes umfasst:
als Reaktion darauf, dass die Topologie der zu verarbeitenden Geometriestromdaten eine Steuerungspaketliste mit k Punkten ist, das Heranziehen der (k*q-k+1)-ten Punktdaten aus den mehreren Punktdaten der zu verarbeitenden Geometriestromdaten als Startpunktdaten, wobei k eine positive ganze Zahl ist,
das Bestimmen der Endpunktdaten der aufzuteilenden Zieldaten im aktuellen Batch aus den mehreren Punktdaten der zu verarbeitenden Geometriestromdaten gemäß den Startpunktdaten, der Anzahl der von jeder der Geometriepipelines pro Batch zu verarbeitenden primitiven Geometrien und der Topologie der zu verarbeitenden Geometriestromdaten Folgendes umfasst:
das Heranziehen der (k*q+k*n-n)-ten Punktdaten aus den mehreren Punktdaten der zu verarbeitenden Geometriestromdaten als Endpunktdaten.

13. Eine Rechenvorrichtung, umfassend einen Speicher und einen Prozessor, wobei der Speicher computerausführbare Anweisungen speichert, die, wenn sie durch den Prozessor ausgeführt werden, den Prozessor befähigen, das Verfahren nach einem der Patentansprüche 1 bis 12 durchzuführen.

14. Ein computerlesbares Speichermedium, auf dem computerausführbare Anweisungen gespeichert sind, die, wenn sie ausgeführt werden, das Verfahren nach einem der Patentansprüche 1 bis 12 implementieren.

## Revendications

1. Un procédé (200) de traitement de données de flux de géométrie, exécuté par un module d'allocation de pipeline de géométrie cible, le module d'allocation de pipeline de géométrie cible étant l'un d'une pluralité de modules d'allocation de pipeline de géométrie compris dans un système de traitement de données de flux de géométrie, le système de traitement de données de flux de géométrie comprenant une pluralité de pipelines de géométrie dont chacun comprend un module d'allocation de pipeline de géométrie et un processeur de pipeline de géométrie, le procédé de traitement de données de flux de géométrie comprenant :
l'acquisition (S201) d'une requête de traitement de données, dans lequel la requête de traitement de données indique une topologie de données de flux de géométrie à traiter et si les données de flux de géométrie à traiter comprennent des données de point de cisaillement, et dans lequel les données de point de cisaillement indiquent qu'aucun sommet commun n'est présent entre une topologie où des données de point précédentes des données de point de cisaillement sont situées et une topologie où des données de point suivantes des données de point de cisaillement sont situées ; le procédé (200) comprend en outre :
en réponse au fait que les données de flux de géométrie à traiter ne comprennent pas les données de point de cisaillement (S202), exécuter :
l'acquisition (S203), à partir des données de flux de géométrie à traiter, de données cibles à scinder dans un lot courant plutôt que l'acquisition de toutes les données de flux de géométrie à traiter, dans lequel les données cibles sont au moins une partie des données de flux de géométrie à traiter ; et
la scission (S204), selon la topologie des données de flux de géométrie à traiter, des données cibles en données de géométries primitives correspondantes à traiter par un processeur de pipeline de géométrie dans un pipeline de géométrie cible, dans lequel le pipeline cible est un pipeline de géométrie auquel appartient le module d'allocation de pipeline de géométrie cible ;
en réponse au fait que les données de flux de géométrie à traiter comprennent les données de point de cisaillement (S301), exécuter :
l'acquisition (S301) des données de flux de géométrie à traiter ;
la scission (S302), selon la topologie des données de flux de géométrie à traiter, des données de flux de géométrie à traiter en données d'une pluralité de géométries primitives ; et la détermination (S303), à partir des données de la pluralité de géométries primitives, de données de géométries primitives à traiter par le pipeline de géométrie cible dans le lot courant, à traiter par le processeur de pipeline de géométrie dans le pipeline de géométrie cible.

2. Le procédé (200) de traitement de données de flux de géométrie selon la revendication 1, dans lequel l'acquisition, à partir des données de flux de géométrie à traiter, des données cibles à scinder dans le lot courant comprend :
la détermination d'un numéro de séquence du pipeline de géométrie cible auquel appartient le module d'allocation de pipeline de géométrie cible, du nombre de pipelines de géométrie de la pluralité, et du nombre de géométries primitives à traiter par chacun des pipelines de géométrie par lot ; et
l'acquisition, à partir des données de flux de géométrie à traiter, des données cibles à scinder dans le lot courant selon le numéro de séquence du pipeline de géométrie cible auquel appartient le module d'allocation de pipeline de géométrie cible, le nombre de pipelines de géométrie de la pluralité, le nombre de géométries primitives à traiter par chacun des pipelines de géométrie par lot, et la topologie des données de flux de géométrie à traiter.

3. Le procédé (200) de traitement de données de flux de géométrie selon la revendication 2, dans lequel l'acquisition, à partir des données de flux de géométrie à traiter, des données cibles à scinder dans le lot courant selon le numéro de séquence du pipeline de géométrie cible auquel appartient le module d'allocation de pipeline de géométrie cible, le nombre de pipelines de géométrie de la pluralité, le nombre de géométries primitives à traiter par chacun des pipelines de géométrie par lot, et la topologie des données de flux de géométrie à traiter comprend :
la détermination (S401), à partir d'une pluralité de données de point des données de flux de géométrie à traiter, de données de point de départ des données cibles à scinder dans le lot courant selon le numéro de séquence du pipeline de géométrie cible auquel appartient le module d'allocation de pipeline de géométrie cible, le nombre de pipelines de géométrie de la pluralité, le nombre de géométries primitives à traiter par chacun des pipelines de géométrie par lot, et la topologie des données de flux de géométrie à traiter ;
la détermination (S402), à partir de la pluralité de données de point des données de flux de géométrie à traiter, de données de point d'arrivée des données cibles à scinder dans le lot courant selon les données de point de départ, le nombre de géométries primitives à traiter par chacun des pipelines de géométrie par lot, et la topologie des données de flux de géométrie à traiter ; et le fait de prendre (S403) des données de point entre les données de point de départ et les données de point d'arrivée parmi la pluralité de données de point des données de flux de géométrie à traiter comme les données cibles à scinder dans le lot courant.

4. Le procédé (200) de traitement de données de flux de géométrie selon la revendication 3, dans lequel la détermination, à partir de la pluralité de données de point des données de flux de géométrie à traiter, des données de point de départ des données cibles à scinder dans le lot courant selon le numéro de séquence du pipeline de géométrie cible auquel appartient le module d'allocation de pipeline de géométrie cible, le nombre de pipelines de géométrie de la pluralité, le nombre de géométries primitives à traiter par chacun des pipelines de géométrie par lot, et la topologie des données de flux de géométrie à traiter comprend :
la détermination d'un numéro d'ordre d'une première géométrie primitive parmi toutes les géométries primitives des données de flux de géométrie à traiter, selon le nombre de pipelines de géométrie de la pluralité, le numéro de séquence du pipeline de géométrie cible auquel appartient le module d'allocation de pipeline de géométrie cible, et le nombre de géométries primitives à traiter par chacun des pipelines de géométrie par lot, dans lequel la première géométrie primitive est une première géométrie primitive parmi les géométries primitives à traiter par le pipeline de géométrie cible dans le lot courant ; et
la détermination, à partir de la pluralité de données de point des données de flux de géométrie à traiter, des données de point de départ des données cibles à scinder dans le lot courant selon le numéro d'ordre et la topologie des données de flux de géométrie à traiter.

5. Le procédé (200) de traitement de données de flux de géométrie selon la revendication 4, dans lequel la détermination du numéro d'ordre de la première géométrie primitive parmi toutes les géométries primitives des données de flux de géométrie à traiter, selon le nombre de pipelines de géométrie de la pluralité, le numéro de séquence du pipeline de géométrie cible auquel appartient le module d'allocation de pipeline de géométrie cible, et le nombre de géométries primitives à traiter par chacun des pipelines de géométrie par lot comprend :
la détermination du numéro d'ordre selon la formule suivante :$q = \left(a-1\right) * n + 1 + n * m * b$
dans lequel q est le numéro d'ordre, m est le nombre de pipelines de géométrie de la pluralité et m est un entier positif supérieur à 1, a est le numéro de séquence du pipeline de géométrie cible auquel appartient le module d'allocation de pipeline de géométrie cible et a est supérieur à 0 et inférieur ou égal à m, n est le nombre de géométries primitives à traiter par chacun des pipelines de géométrie par lot et n est un entier positif, b est un nombre de lots qui ont été traités par le module d'allocation de pipeline de géométrie cible et b est un nombre non négatif.

6. Le procédé (200) de traitement de données de flux de géométrie selon la revendication 5, dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une liste de points, le fait de prendre des q-ièmes données de point parmi la pluralité de données de point des données de flux de géométrie à traiter comme les données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
le fait de prendre des (q+n-1)-ièmes données de point parmi la pluralité de données de point des données de flux de géométrie à traiter comme les données de point d'arrivée.

7. Le procédé (200) de traitement de données de flux de géométrie selon la revendication 5, dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une liste de lignes, le fait de prendre des (2*q-1)-ièmes données de point parmi la pluralité de données de point des données de flux de géométrie à traiter comme les données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
le fait de prendre des (2*q+2*n-2)-ièmes données de point parmi la pluralité de données de point des données de flux de géométrie à traiter comme les données de point d'arrivée,
ou dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une liste de lignes avec des informations d'adjacence, le fait de prendre des (4*q-3)-ièmes données de point parmi la pluralité de données de point des données de flux de géométrie à traiter comme les données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
la prise des données de point de rang (4*q+4*n-4) parmi la pluralité de données de point des données de flux de géométrie à traiter comme données de point d'arrivée.

8. Le procédé (200) de traitement de données de flux de géométrie selon la revendication 5, dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une bande de lignes, la prise des données de point de rang q parmi la pluralité de données de point des données de flux de géométrie à traiter comme données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
la prise des données de point de rang (q+n+1) parmi la pluralité de données de point des données de flux de géométrie à traiter comme données de point d'arrivée,
ou dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une bande de lignes avec des informations d'adjacence, la prise des données de point de rang q parmi la pluralité de données de point des données de flux de géométrie à traiter comme données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
la prise des données de point de rang (q+n+3) parmi la pluralité de données de point des données de flux de géométrie à traiter
comme données de point d'arrivée.

9. Le procédé (200) de traitement de données de flux de géométrie selon la revendication 5, dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une boucle de lignes, la prise des données de point de rang q parmi la pluralité de données de point des données de flux de géométrie à traiter comme données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
en réponse au fait qu'il n'est pas requis que le processeur de pipeline de géométrie du pipeline de géométrie cible
traite une dernière donnée de ligne parmi toutes les données de ligne des données de flux de géométrie à traiter, la prise des données de point de rang (q+n+1) parmi la pluralité de données de point des données de flux de géométrie à traiter comme données de point d'arrivée ; et
en réponse au fait qu'il est requis que le processeur de pipeline de géométrie du pipeline de géométrie cible traite la dernière donnée de ligne parmi toutes les données de ligne des données de flux de géométrie à traiter, la prise des premières données de point parmi la pluralité de données de point des données de flux de géométrie à traiter comme données de point d'arrivée.

10. Le procédé (200) de traitement de données de flux de géométrie selon la revendication 5, dans lequel la détermination,
à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une liste de triangles, la prise des données de point de rang (3*q-2) parmi la pluralité de données de point des données de flux de géométrie à traiter comme données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
la prise des données de point de rang (3*q+3*n-3) parmi la pluralité de données de point des données de flux de géométrie à traiter comme données de point d'arrivée,
ou dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une liste de triangles avec des informations d'adjacence, la prise des données de point de rang (6*q-5) parmi la pluralité de données de point des données de flux de géométrie à traiter comme données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
la prise des données de point de rang (6*q+6*n-6) parmi la pluralité de données de point des données de flux de géométrie à traiter comme données de point d'arrivée.

11. Le procédé (200) de traitement de données de flux de géométrie selon la revendication 5, dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une bande de triangles, la prise des données de point de rang q parmi la pluralité de données de point des données de flux de géométrie à traiter comme données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
la prise des données de point de rang (q+n+1) parmi la pluralité de données de point des données de flux de géométrie à traiter comme données de point d'arrivée,
ou dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie est une bande de triangles avec des informations d'adjacence et que q est égal à 1, la prise des premières données de point parmi la pluralité de données de point des données de flux de géométrie à traiter comme données de point de départ ; et
en réponse au fait que la topologie des données de flux de géométrie à traiter est une bande de triangles avec des informations d'adjacence et que q est supérieur à 1, la prise des données de point de rang (2*q-4) parmi la pluralité de données de point des données de flux de géométrie à traiter comme données de point de départ,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
en réponse au fait que q est égal à 1, la prise des données de point de rang (2*n+7) parmi la pluralité de données de point des données de flux de géométrie à traiter comme données de point d'arrivée ; et
en réponse au fait que q est supérieur à 1, la prise des données de point de rang (2*q-4+2n+8) parmi la pluralité de données de point des données de flux de géométrie à traiter comme données de point d'arrivée.

12. Le procédé (200) de traitement de données de flux de géométrie selon la revendication 5, dans lequel la détermination, à partir de la pluralité de données de point des données de flux de géométrie à traiter, des données de point de départ des données cibles à scinder dans le lot courant selon le numéro d'ordre et la topologie des données de flux de géométrie à traiter comprend :
en réponse au fait que la topologie des données de flux de géométrie à traiter est une liste de paquets de commande à k points, la prise des données de point de rang (k*q-k+1) parmi la pluralité de données de point des données de flux de géométrie à traiter comme données de point de départ, dans lequel k est un entier positif,
la détermination, à partir de la pluralité de données de point des données de flux de géométrie à traiter, des données de point d'arrivée des données cibles à scinder dans le lot courant selon les données de point de départ, le nombre de géométries primitives à traiter par chacun des pipelines de géométrie par lot, et la topologie des données de flux de géométrie à traiter comprend :
la prise des données de point de rang (k*q+k*n-n) parmi la pluralité de données de point des données de flux de géométrie à traiter comme données de point d'arrivée.

13. Un dispositif informatique, comprenant une mémoire et un processeur, dans lequel la mémoire stocke des instructions exécutables par ordinateur qui, lorsqu'elles sont exécutées par le processeur, permettent au processeur d'exécuter le procédé selon l'une quelconque des revendications 1 à 12.

14. Un support de stockage lisible par ordinateur sur lequel sont stockées des instructions exécutables par ordinateur qui, lorsqu'elles sont exécutées, mettent en œuvre le procédé selon l'une quelconque des revendications 1 à 12.
